# EUROPEAN PATENT APPLICATION

(11) **EP 4 776 805 A1**
(43) Date of publication of application: **15.07.2026**
(21) Application number: 26150911.1
(22) Date of filing: 08.01.2026
(51) Int. Cl.: H10K 59/12, H10K 71/00

(54) **METHOD OF MANUFACTURING DISPLAY DEVICE, DISPLAY DEVICE, AND ELECTRONIC DEVICE**

(30) Priority: 14.01.2025 KR 20250005291
(71) Applicant: Samsung Display Co., Ltd., Yongin-si, Gyeonggi-do (KR)
(72) Inventor: Park, Sung Dong, 17113 Yongin-si, Gyeonggi-do (KR); Kim, Ji Hoon, 17113 Yongin-si, Gyeonggi-do (KR); Noh, Sung Ho, 17113 Yongin-si, Gyeonggi-do, (KR); Lee, Kwang Min, 17113 Yongin-si, Gyeonggi-do, (KR)
(74) Representative: Gulde & Partner

(57) **Abstract**

A method of manufacturing a display device includes forming a plurality of display cells on a first surface of a mother substrate which includes the first surface and a second surface facing the first surface, forming a plurality of first sketch lines extending from the first surface toward the second surface and located along edges of the plurality of display cells, based on irradiating a laser beam onto at least one of the first surface or the second surface, slimming the mother substrate to form a slimmed mother substrate based on spraying an etchant onto the second surface, and separating the plurality of display cells from the slimmed mother substrate based on dividing the mother substrate based on positioning a stage that includes first step portions in relation to the slimmed mother substrate such that each first step portion is adjacent to a separate first sketch line.

## Description

### BACKGROUND

### 1. Field

The present inventive concepts relate to methods of manufacturing a display device, display devices, and electronic devices.

### 2. Description of the Related Art

As the information society develops, demands for display devices for displaying images are increasing in various forms. The display devices may be flat panel display devices such as liquid crystal displays, field emission displays, and light emitting displays.

A display device includes a display area displaying images and a non-display area located around the display area, for example, surrounding the display area. Recently, a width of the non-display area has been gradually reduced to increase immersion in the display area and enhance aesthetic appearance of the display device.

In a process of manufacturing the display device, the display device may be formed by cutting a mother substrate along a plurality of display cells formed on the mother substrate including the display cells.

The non-display area may include a first non-display area in which lines and circuits for driving the display area are located and a second non-display area which corresponds to a margin for a cutting process in the manufacturing process of the display device. Since there is a limit to reducing the number of lines and circuits in the first non-display area, a method of reducing a width of the second non-display area is being researched.

### SUMMARY

The invention is defined by the appended claims. The description that follows is subjected to this limitation. Any disclosure lying outside the scope of said claims is only intended for illustrative as well as comparative purposes.

Example embodiments of the present inventive concepts provide a method of manufacturing a display device, a display device, and an electronic device, in which a width of a non-display area is reduced or minimized.

Example embodiments of the present inventive concepts also provide a method of manufacturing a display device, a display device, and an electronic device, in which reliability is improved by reducing or preventing penetration of an etchant.

However, example embodiments of the present inventive concepts are not restricted to the example embodiments set forth herein. The above and other example embodiments of the present inventive concepts will become more apparent to one of ordinary skill in the art to which the present inventive concepts pertain by referencing the detailed description of the present inventive concepts given below.

According to some example embodiments of the present inventive concepts, a method of manufacturing a display device includes forming a plurality of display cells on a first surface of a mother substrate which includes the first surface and a second surface facing the first surface, forming a plurality of first sketch lines, which extend from the first surface toward the second surface and are located along edges of the plurality of display cells, based on irradiating a laser beam onto at least one of the first surface or the second surface, slimming the mother substrate to form a slimmed mother substrate based on spraying an etchant onto the second surface, and separating the plurality of display cells from the slimmed mother substrate based on dividing the mother substrate using a stage, the stage including a plurality of first step portions, the dividing including positioning the stage in relation to the slimmed mother substrate such that each first step portion of the plurality of first step portions is adjacent to a separate first sketch line of the plurality of first sketch lines.

In some example embodiments, a thickness of the slimmed mother substrate is greater than a depth of each first sketch line of the plurality of first sketch lines.

In some example embodiments, the slimming the mother substrate includes reducing the thickness of the mother substrate by an etched thickness, and a distance between the second surface and the plurality of first sketch lines in the slimmed mother substrate is 10% to 20% of the etched thickness.

In some example embodiments, the depth of each first sketch line of the plurality of first sketch lines is 135 µm to 175 µm.

In some example embodiments, the dividing includes positioning the stage in relation to the slimmed mother substrate such that, in a plan view, the each first step portion is located at one side or an opposite side of the separate first sketch line.

In some example embodiments, the dividing includes positioning the stage in relation to the slimmed mother substrate such that, in the plan view, the plurality of first step portions are surrounded by separate, respective first sketch lines of the plurality of first sketch lines.

In some example embodiments, the dividing includes positioning the stage in relation to the slimmed mother substrate such that, in the plan view, the plurality of first sketch lines are surrounded by separate, respective first step portions of the plurality of first step portions.

In some example embodiments, each first step portion of the plurality of first step portions is a fence-type step portion, and the dividing includes positioning the stage in relation to the slimmed mother substrate such that, in a plan view, the plurality of first step portions surround separate, respective display cells of the plurality of display cells.

In some example embodiments, each first step portion of the plurality of first step portions includes a plurality of island-type step portions spaced apart from each other.

In some example embodiments, the stage comprises a plurality of suction holes, the plurality of suction holes including at least one of: one or more first suction holes surrounded by one first step portion of the plurality of first step portions in a plan view, and one or more second suction holes between at least two separate first step portions of the plurality of first step portions in the plan view.

According to some example embodiments of the present inventive concepts, a method of manufacturing a display device may include forming a plurality of display cells on a first surface of a mother substrate which includes the first surface and a second surface facing the first surface, forming a plurality of second sketch lines, which extend from the first surface toward the second surface, based on irradiating a laser beam onto at least one of the first surface or the second surface, slimming the mother substrate to form a slimmed mother substrate based on spraying an etchant onto the second surface, and forming a through hole in a display area in each display cell of the plurality of display cells based on dividing the slimmed mother substrate using a stage, the stage including a plurality of second step portions, the dividing including positioning the stage in relation to the slimmed mother substrate such that each second step portion of the plurality of second step portions is adjacent to a separate second sketch line of the plurality of second sketch lines.

In some example embodiments, a thickness of the slimmed mother substrate is greater than a depth of each second sketch line of the plurality of first sketch lines.

In some example embodiments, the slimming the mother substrate includes reducing the thickness of the mother substrate by an etched thickness, and a distance between the second surface and the plurality of second sketch lines in the slimmed mother substrate is 10% to 20% of the etched thickness.

In some example embodiments, the depth of each first sketch line of the plurality of first sketch lines is 135 µm to 175 µm.

In some example embodiments, the dividing includes positioning the stage in relation to the slimmed mother substrate such that, in a plan view, the each second step portion is located at one side or an opposite side of the separate second sketch line.

In some example embodiments, the dividing includes positioning the stage in relation to the slimmed mother substrate such that, in the plan view, the plurality of second step portions are surrounded by separate, respective second sketch lines of the plurality of second sketch lines.

In some example embodiments, the dividing includes positioning the stage in relation to the slimmed mother substrate such that, in the plan view, the plurality of second sketch lines are surrounded by separate, respective second step portions of the plurality of second step portions.

In some example embodiments, each second step portion of the plurality of second step portions is a fence-type step portion, and the dividing includes positioning the stage in relation to the slimmed mother substrate such that, in a plan view, the plurality of second step portions surround separate, respective display cells of the plurality of display cells.

In some example embodiments, each second step portion of the plurality of second step portions includes a plurality of island-type step portions spaced apart from each other.

In some example embodiments, the stage comprises a plurality of suction holes, the plurality of suction holes including at least one of one or more first suction holes located in an area having a periphery defined by one first step portion of the plurality of first step portions in a plan view, or one or more second suction holes external to the area in the plan view.

According to some example embodiments of the present inventive concepts, a method of manufacturing a display device may include forming a plurality of display cells on a first surface of a mother substrate which includes the first surface and a second surface facing the first surface, a plurality of first sketch lines extending from the first surface toward the second surface and located along edges of the plurality of display cells, based on irradiating a first laser beam onto at least one of the first surface or the second surface, forming a plurality of second sketch lines extending from the first surface toward the second surface, based on irradiating a second laser beam onto at least one of the first surface or the second surface, slimming the mother substrate to form a slimmed mother substrate based on spraying an etchant onto the second surface, and separating the plurality of display cells from the slimmed mother substrate and forming a through hole in a display area in each display cell of the plurality of display cells based on dividing the slimmed mother substrate using a pressing jig, the pressing jig including a plurality of first step portions and a plurality of second step portions, the dividing including positioning the pressing jig in relation to the slimmed mother substrate such that each first step portion of the plurality of first step portions is adjacent to a separate first sketch line of the plurality of first sketch lines, and each second step portion of the plurality of second step portions is adjacent to a separate second sketch line of the plurality of second sketch lines.

According to some example embodiments of the present inventive concepts, a display device may include a substrate including a display area and a non-display area at least partially surrounding the display area, a light emitting element layer on the substrate, the light emitting element layer including a plurality of light emitting elements on the display area, and a thin-film transistor layer between the substrate and the light emitting element layer.

In some example embodiments, the display device may further comprise a through hole in the display area.

According to some example embodiments of the present inventive concepts, there is provided an electronic device including, the display device, a processor configured to provide an operation signal to the display device, and a power module configured to supply a voltage to the display device and the processor.

According to a method of manufacturing a display device, a display device, and an electronic device according to some example embodiments of the present inventive concepts, a width of a non-display area can be reduced or minimized.

According to a method of manufacturing a display device, a display device, and an electronic device according to some example embodiments of the present inventive concepts, reliability can be improved by reducing or preventing penetration of an etchant.

However, the effects of the present inventive concepts are not restricted to the effects set forth herein. The above and other effects of the present inventive concepts will become more apparent to one of daily skill in the art to which the present inventive concepts pertain by referencing the claims.

### BRIEF DESCRIPTION OF THE DRAWINGS

These and/or other example embodiments will become apparent and more readily appreciated from the following description of some example embodiments, taken in conjunction with the accompanying drawings in which:
FIG. 1 is a perspective view of a display device according to some example embodiments;
FIG. 2 is a plan view illustrating a display panel and driving integrated circuits (ICs) according to some example embodiments;
FIG. 3 is a cross-sectional view taken along line X1-X1' of FIG. 1 according to some example embodiments;
FIG. 4 is a cross-sectional view illustrating a bent state of the display device of FIG. 3 according to some example embodiments;
FIG. 5 is a cross-sectional view of an example of a display area of the display device in region X of FIG. 4 according to some example embodiments;
FIG. 6 is an enlarged view of area A of FIG. 2 according to some example embodiments;
FIG. 7 is a cross-sectional view taken along line X2-X2' of FIG. 6 according to some example embodiments;
FIG. 8 is an enlarged view of area C of FIG. 7 according to some example embodiments;
FIG. 9 is an enlarged view of area B of FIG. 2 according to some example embodiments;
FIG. 10 is a cross-sectional view taken along line X3-X3' of FIG. 9 according to some example embodiments;
FIG. 11 is an enlarged view of area D of FIG. 10 according to some example embodiments;
FIG. 12 is a flowchart illustrating a method of manufacturing a display device according to some example embodiments;
FIG. 13 is an example view illustrating depths of laser irradiation areas formed by a laser processing apparatus according to some example embodiments;
FIG. 14 is a perspective view illustrating operation S110 of FIG. 12 according to some example embodiments;
FIG. 15 is a perspective view illustrating operation S130 of FIG. 12 according to some example embodiments;
FIG. 16 is a perspective view illustrating operation S140 of FIG. 12 according to some example embodiments;
FIG. 17 is a perspective view illustrating operation S160 of FIG. 12 according to some example embodiments;
FIG. 18 is a perspective view illustrating operation S170 of FIG. 12 according to some example embodiments;
FIG. 19 is a plan view illustrating operation S170 of FIG. 12 according to some example embodiments;
FIG. 20 is a perspective view illustrating operation S170 of FIG. 12 according to some example embodiments;
FIG. 21 is a cross-sectional view illustrating operation S120 of FIG. 12 according to some example embodiments;
FIG. 22 is a cross-sectional view illustrating operation S130 of FIG. 12 according to some example embodiments;
FIG. 23 is a cross-sectional view illustrating operation S160 of FIG. 12 according to some example embodiments;
FIGS. 24, 25, and 26 are cross-sectional views illustrating operation S170 of FIG. 12 according to some example embodiments;
FIG. 27 is a cross-sectional view illustrating operation S120 of FIG. 12 according to some example embodiments;
FIG. 28 is a cross-sectional view illustrating operation S140 of FIG. 12;
FIG. 29 is a cross-sectional view illustrating operation S160 of FIG. 12;
FIGS. 30, 31, and 32 are cross-sectional views illustrating operation S170 of FIG. 12;
FIG. 33 is a plan view illustrating operation S170 in a method of manufacturing a display device according to some example embodiments;
FIGS. 34 and 35 are cross-sectional views illustrating operation S170 in the method of manufacturing the display device shown in FIG. 33 according to some example embodiments;
FIG. 36 is a plan view illustrating operation S170 in a method of manufacturing a display device according to some example embodiments;
FIG. 37 is a cross-sectional view illustrating operation S170 in a method of manufacturing a display device according to some example embodiments;
FIG. 38 is a block diagram of an electronic device according to some example embodiments; and
FIG. 39 is a schematic diagram of electronic devices according to some ex ample embodiments.

### DETAILED DESCRIPTION

The inventive concepts will now be described more fully hereinafter with reference to the accompanying drawings, in which some example embodiments of the inventive concepts are shown. This inventive concepts may, however, be embodied in different forms and should not be construed as limited to the example embodiments set forth herein. Rather, these example embodiments are provided so that the inventive concepts will be thorough and complete, and will fully convey the scope of the inventive concepts to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms first, second, etc. may be used herein to describe various elements, these elements should not be limited by these terms. These terms are only used to distinguish one element from another element. Thus, a first element discussed below could be termed a second element without departing from the teachings of the present inventive concepts. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to another elements or features as shown in the figures.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

It will be understood that elements and/or properties thereof (e.g., structures, surfaces, directions, or the like), which may be referred to as being "perpendicular," "parallel," or the like with regard to other elements and/or properties thereof (e.g., structures, surfaces, directions, or the like) may be "perpendicular," "parallel," or the like or may be "substantially perpendicular," "substantially parallel," or the like, respectively, with regard to the other elements and/or properties thereof.

Elements and/or properties thereof (e.g., structures, surfaces, directions, or the like) that are "substantially perpendicular" or "substantially parallel" with regard to other elements and/or properties thereof will be understood to be "perpendicular" or "parallel", respectively, with regard to the other elements and/or properties thereof within manufacturing tolerances and/or material tolerances and/or have a deviation in magnitude and/or angle from "perpendicular" or "parallel", respectively, with regard to the other elements and/or properties thereof that is equal to or less than 10% (e.g., a. tolerance of ±10%).

It will be understood that elements and/or properties thereof may be recited herein as being "the same" as other elements and/or properties thereof, and it will be further understood that elements and/or properties thereof recited herein as being "the same" as other elements and/or properties thereof may be "the same" as or "substantially the same" as the other elements and/or properties thereof. Elements and/or properties thereof that are "substantially the same" as other elements and/or properties thereof will be understood to include elements and/or properties thereof that are the same as the other elements and/or properties thereof within manufacturing tolerances and/or material tolerances. Elements and/or properties thereof that are the same or substantially the same as other elements and/or properties thereof may be structurally the same or substantially the same, functionally the same or substantially the same, and/or compositionally the same or substantially the same.

While the term "same" may be used in description of some example embodiments, it should be understood that some imprecisions may exist. Thus, when one element or property is referred to as being the same as another element or property, it should be understood that the element or property is the same as another element or property within a desired manufacturing or operational tolerance range (e.g., ±10%).

It will be understood that elements and/or properties thereof described herein as being "substantially" the same as one or more other elements and/or properties thereof encompasses elements and/or properties thereof that have a relative difference in magnitude with the one or more other elements and/or properties thereof that is equal to or less than 10%. Further, regardless of whether elements and/or properties thereof are modified as "substantially," it will be understood that these elements and/or properties thereof should be construed as including a manufacturing or operational tolerance (e.g., ±10%) around the stated elements and/or properties thereof.

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ± 10%) around the stated numerical values or shapes. When ranges are specified, the range includes all values therebetween such as increments of 0.1%.

As described herein, when an operation is described to be performed, or an effect such as a structure is described to be established "by" or "through" performing additional operations, it will be understood that the operation may be performed and/or the effect/structure may be established "based on" the additional operations, which may include performing said additional operations alone or in combination with other further additional operations.

As described herein, an element that is described to be "spaced apart" from another element, in general and/or in a particular direction (e.g., vertically spaced apart, laterally spaced apart, etc.) and/or described to be "separated from" the other element, may be understood to be isolated from direct contact with the other element, in general and/or in the particular direction (e.g., isolated from direct contact with the other element in a vertical direction, isolated from direct contact with the other element in a lateral or horizontal direction, etc.). Similarly, elements that are described to be "spaced apart" from each other, in general and/or in a particular direction (e.g., vertically spaced apart, laterally spaced apart, etc.) and/or are described to be "separated" from each other, may be understood to be isolated from direct contact with each other, in general and/or in the particular direction (e.g., isolated from direct contact with each other in a vertical direction, isolated from direct contact with each other in a lateral or horizontal direction, etc.). Similarly, a structure described herein to be between two other structures to separate the two other structures from each other may be understood to be configured to isolate the two other structures from direct contact with each other.

Hereinafter, some example embodiments of the present inventive concepts will be described in detail with reference to the accompanying drawings.

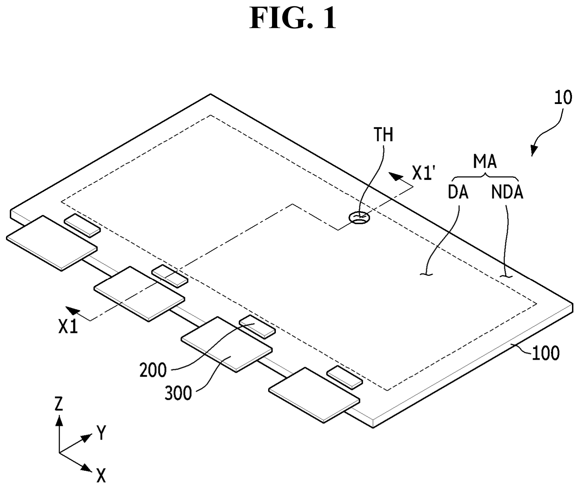

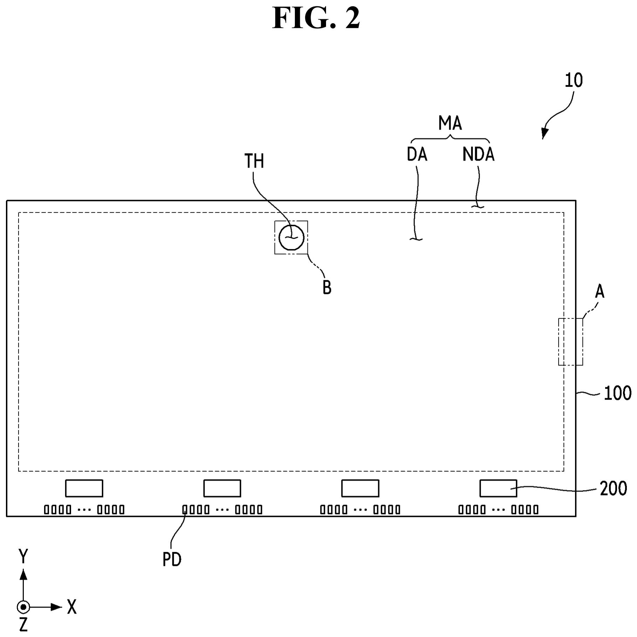

FIG. 1 is a perspective view of a display device 10 according to some example embodiments. FIG. 2 is a plan view illustrating a display panel 100 and driving integrated circuits (ICs) 200 according to some example embodiments.

Referring to FIGS. 1 and 2, the display device 10 according to some example embodiments is a device for displaying moving images or still images. The display device 10 may be used as a display screen in portable electronic devices such as mobile phones, smartphones, tablet personal computers (PCs), smart watches, watch phones, mobile communication terminals, electronic notebooks, electronic books, portable multimedia players (PMPs), navigation devices and ultra-mobile PCs (UMPCs), as well as in various products such as televisions, notebook computers, monitors, billboards, and Internet of things (IoT) devices.

The display device 10 according to some example embodiments may be a light emitting display device such as an organic light emitting display device using an organic light emitting diode, a quantum dot light emitting display device including a quantum dot light emitting layer, an inorganic light emitting display device including an inorganic semiconductor, or a micro- or nano-light emitting display device using a micro- or nano-light emitting diode. A case where the display device 10 is an organic light emitting display device will be mainly described below, but the present inventive concepts are not limited thereto.

The display device 10 according to some example embodiments may include the display panel 100, the driving ICs 200, and circuit boards 300.

The display panel 100 may be shaped like a rectangular plane having long sides in a first direction (X-axis direction) and short sides in a second direction (Y-axis direction) crossing the first direction (X-axis direction). Each corner where a long side extending in the first direction (X-axis direction) meets a short side extending in the second direction (Y-axis direction) may be right-angled or may be rounded with a curvature. The planar shape of the display panel 100 is not limited to a quadrangular shape but may also be another polygonal shape, a circular shape, or an oval shape.

In the drawings, the first direction (X-axis direction) and the second direction (Y-axis direction) are horizontal directions crossing each other and extending parallel to a plane, which may be parallel to one or more surfaces of the display panel 100 and/or the mother substrate MSUB as described herein. For example, the first direction (X-axis direction) and the second direction (Y-axis direction) may be orthogonal to each other and may each extend parallel to an upper surface of the display panel 100 and/or a first surface US_M of a mother substrate as described herein. In addition, a third direction (Z-axis direction) may be a vertical direction crossing, for example, orthogonal to the first direction (X-axis direction) and the second direction (Y-axis direction) and which may extend orthogonal (perpendicular) to a plane, which may be parallel to one or more surfaces of the display panel 100 and/or the mother substrate MSUB as described herein. In the present specification, a direction indicated by an arrow of each of the first through third directions (X-, Y- and Z-axis directions) may be referred to as one side, and the opposite direction may be referred to as the other side and/or "another side".

As described herein, where an element (e.g., a portion, a pattern, a layer, a structure, or the like) is described to overlap or be overlapping another element, the element may be understood to overlap or be overlapping the other element in the third direction (Z-axis direction). As described herein, where an element is described to overlap or be overlapping another element, the element may at least partially overlap the other element in the third direction (Z-axis direction), such that the element may partially overlap the other element in the third direction (Z-axis direction) or may entirely overlap the other element in the third direction (Z-axis direction).

The display panel 100 may be formed flat or substantially flat, but example embodiments of the present inventive concepts are not limited thereto. For example, the display panel 100 may include curved portions formed at left and right ends and having a constant or varying curvature. In addition, the display panel 100 may be formed to be flexible so that it can be curved, bent, folded, or rolled.

The display panel 100 may include a display area DA configured to display an image and a non-display area NDA located around the display area DA (e.g., at least partially or entirely surrounding the display area DA in a plane extending in the first and second directions). The display area DA and the non-display area NDA may form (e.g., define) a main area MA.

The display area DA may occupy most (e.g., a majority) of the area of the display panel 100. The display area DA may be located in a center of the display panel 100. Pixels, each including a plurality of emission areas, may be located in the display area DA to display an image.

The non-display area NDA may neighbor (e.g., may be adjacent to, may be directly adjacent to, etc.) the display area DA. The non-display area NDA may be an area outside (e.g., external to, separate from, etc.) the display area DA. The non-display area NDA may surround the display area DA (e.g., at least partially or entirely surround the display area DA in a plane extending parallel to an upper and/or lower surface of the display panel 100). The non-display area NDA may be a border area of the display panel 100.

Display pads PD to be connected to the circuit boards 300 may be located in the non-display area NDA. The display pads PD may be located on an edge of the display panel 100. For example, the display pads PD may be located on a lower edge of the display panel 100.

The driving ICs 200 may generate data voltages, power voltages, scan timing signals, etc. The driving ICs 200 may output the data voltages, the power voltages, the scan timing signals, etc.

The driving ICs 200 may be located in the non-display area NDA between the display pads PD and the display area DA. Each of the driving ICs 200 may be attached to the non-display area NDA of the display panel 100 using a chip on glass (COG) method. In some example embodiments, each of the driving ICs 200 may be attached to a circuit board 300 using a chip on plastic (COP) method.

The circuit boards 300 may be located on the display pads PD arranged on an edge of the display panel 100. The circuit boards 300 may be attached to the display pads PD using a conductive adhesive member such as an anisotropic conductive film or an anisotropic conductive adhesive. Accordingly, the circuit boards 300 may be electrically connected to signal lines of the display panel 100. Each of the circuit boards 300 may be a flexible printed circuit board or a flexible film such as a chip on film.

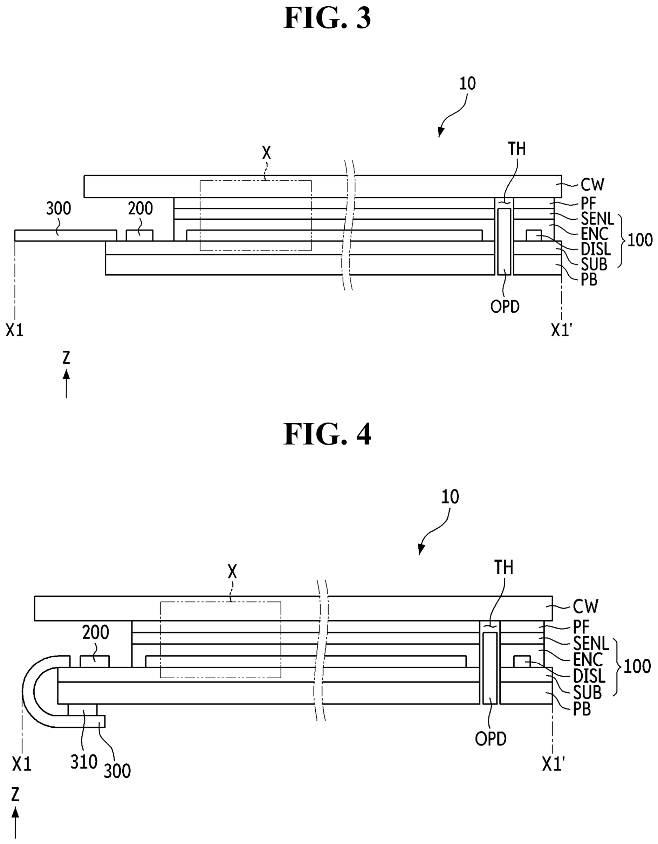

FIG. 3 is a cross-sectional view taken along line X1-X1' of FIG. 1 according to some example embodiments. FIG. 4 is a cross-sectional view illustrating a bent state of the display device 10 of FIG. 3 according to some example embodiments.

Referring to FIGS. 3 and 4 in addition to FIGS. 1 and 2, the display device 10 according to some example embodiments may include the display panel 100, a polarizing film PF, a cover window CW, an under-panel cover PB, a driving IC 200, and a circuit board 300. The display panel 100 may include a substrate SUB, a display layer DISL, an encapsulation layer ENC, and a sensor electrode layer SENL.

The substrate SUB may have rigidity. For example, the substrate SUB may include glass. The substrate SUB may include ultra-thin glass having a thickness of about 500 µm or less. Preferably, the thickness of the substrate SUB may be about 200 µm. In some example embodiments, the substrate SUB may include a rigid first substrate and a flexible second substrate including polymer resin.

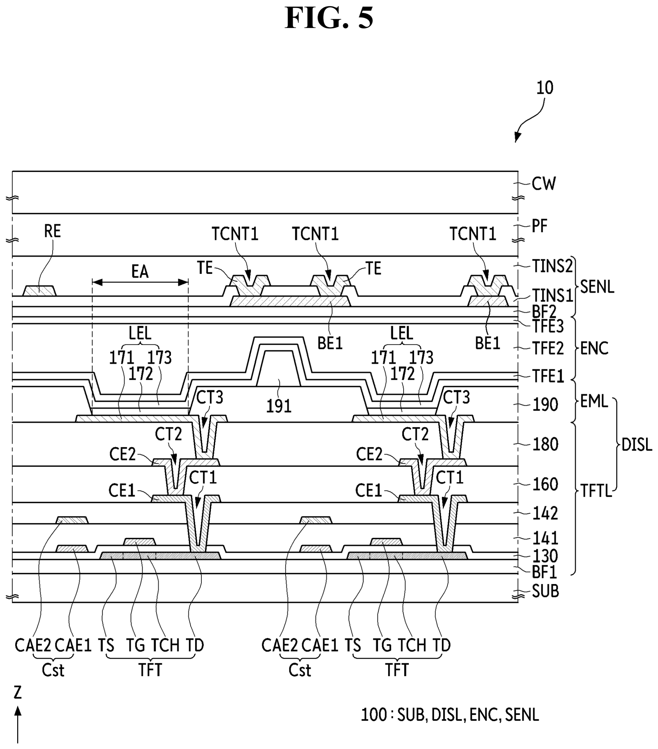

The display layer DISL may be located on a first surface of the substrate SUB. The display layer DISL may be a layer displaying (e.g., configured to display) an image. The display layer DISL may include a thin-film transistor layer TFTL (see FIG. 5) in which thin-film transistors are formed and a light emitting element layer EML (see FIG. 5) in which light emitting elements emitting light are located in emission areas.

The display area DA of the display layer DISL may include scan lines, data lines, power lines, etc. to configure that the emission areas to emit light. The non-display area NDA of the display layer DISL may include a scan driving circuit unit outputting scan signals (e.g., configured to transmit scan signals) to the scan lines and fan-out lines connecting the data lines and the driving IC 200.

The encapsulation layer ENC may be a layer for encapsulating the light emitting element layer EML of the display layer DISL to reduce, minimize, or prevent penetration of oxygen or moisture into the light emitting element layer EML of the display layer DISL. The encapsulation layer ENC may be located on the display layer DISL. The encapsulation layer ENC may be located on upper and side surfaces of the display layer DISL. The encapsulation layer ENC may cover the display layer DISL.

The sensor electrode layer SENL may be located on the display layer DISL. The sensor electrode layer SENL may include sensor electrodes. The sensor electrode layer SENL may sense a user's touch using the sensor electrodes.

The polarizing film PF may be located on the sensor electrode layer SENL. The polarizing film PF may be located on the display panel 100 to reduce reflection of external light. The polarizing film PF may include a first base member, a linear polarizer, a phase retardation film such as a quarter-wave (λ/4) plate, and a second base member. The first base member, the phase retardation film, the linear polarizer, and the second base member of the polarizing film PF may be sequentially stacked on the display panel 100.

The cover window CW may be located on the polarizing film PF. The cover window CW may be attached onto the polarizing film PF by a transparent adhesive member such as an optically clear adhesive (OCA) film.

The under-panel cover PB may be located on a second surface of the substrate SUB of the display panel 100. The second surface of the substrate SUB may be a surface opposite the first surface. The under-panel cover PB may be attached to the second surface of the substrate SUB of the display panel 100 through an adhesive member. The adhesive member may be a pressure sensitive adhesive.

The under-panel cover PB may include at least one of a light blocking member for absorbing light incident from the outside (e.g., incident light from an ambient environment that is external to the display device 10), a buffer member for absorbing external impact, and a heat dissipation member for efficiently dissipating the heat of the display panel 100.

The driving IC 200 and the circuit board 300 may be bent toward the bottom of the display panel 100 as illustrated in FIG. 4. The circuit board 300 may be attached to a lower surface of the under-panel cover PB by an adhesive member 310. The adhesive member 310 may be a pressure sensitive adhesive.

The display device 10 may further include a through hole TH and an optical device OPD located in the through hole TH.

The through hole TH may be a hole that can transmit light and may be a physical hole penetrating not only the display panel 100 but also the under-panel cover PB and the polarizing film PF. For example, the through hole TH may penetrate the substrate SUB, the display layer DISL, the encapsulation layer ENC, and the sensor electrode layer SENL of the display panel 100. Accordingly, the through hole TH may be at least partially defined by one or more inner surfaces of at least one of the substrate SUB, the display layer DISL, the encapsulation layer ENC, and the sensor electrode layer SENL. However, example embodiments of the present inventive concepts are not limited thereto, and the through hole TH may penetrate the under-panel cover PB but may not penetrate the display panel 100 and the polarizing film PF. The cover window CW may cover the through hole TH (e.g., to cover one end of the through hole TH as shown in FIGS. 3 and 4).

The optical device OPD may be spaced apart from the display panel 100, the under-panel cover PB, and the polarizing film PF. The optical device OPD may be an optical sensor that senses light incident through the through hole TH. The optical device OPD may include a proximity sensor, an illuminance sensor, a camera sensor, or any combination thereof.

FIG. 5 is a cross-sectional view of an example of the display area DA of the display device 10 in region X of FIGS. 3 and 4 according to some example embodiments.

Referring to FIG. 5, the display device 10 according to some example embodiments may include the display panel 100, the polarizing film PF, and the cover window CW.

In some example embodiments, the display panel 100 may be an organic light emitting display panel including light emitting elements LEL, each including an organic light emitting layer 172. The display panel 100 may include the substrate SUB, the display layer DISL, the encapsulation layer ENC, and the sensor electrode layer SENL. The display layer DISL may include the thin-film transistor layer TFTL including a plurality of thin-film transistors and the light emitting element layer EML including a plurality of light emitting elements.

The substrate SUB may have rigidity. For example, the substrate SUB may include glass. The substrate SUB may include ultra-thin glass having a thickness (e.g., a thickness in the third direction) of about 500 µm or less. Preferably, the thickness of the substrate SUB (e.g., a thickness in the third direction) may be about 200 µm. In some example embodiments, the substrate SUB may include a rigid first substrate and a flexible second substrate including polymer resin.

The display layer DISL may include the thin-film transistor layer TFTL including a plurality of thin-film transistors and the light emitting element layer EML including a plurality of light emitting elements.

The thin-film transistor layer TFTL may include a first buffer layer BF1, thin-film transistors TFT, a gate insulating layer 130, a first interlayer insulating layer 141, capacitors Cst, a second interlayer insulating layer 142, a first data metal layer, a first organic layer 160, a second data metal layer, and a second organic layer 180.

The first buffer layer BF1 may be located on the substrate SUB. The first buffer layer BF1 may include an inorganic material such as a silicon nitride layer, a silicon oxynitride layer, a silicon oxide layer, a titanium oxide layer, or an aluminum oxide layer. In some example embodiments, the first buffer layer BF1 may be a multilayer in which a plurality of layers selected from a silicon nitride layer, a silicon oxynitride layer, a silicon oxide layer, a titanium oxide layer, and an aluminum oxide layer are alternately stacked.

An active layer including a channel region TCH, a source region TS, and a drain region TD of each thin-film transistor TFT may be located on the first buffer layer BF1. The active layer may include polycrystalline silicon, monocrystalline silicon, low-temperature polycrystalline silicon, amorphous silicon, or an oxide semiconductor material. When the active layer includes polycrystalline silicon or an oxide semiconductor material, the source region TS and the drain region TD in the active layer may be conductive regions doped with ions or impurities to have conductivity.

The gate insulating layer 130 may be located on the active layers of the thin-film transistors TFT. The gate insulating layer 130 may include an inorganic layer, for example, a silicon nitride layer, a silicon oxynitride layer, a silicon oxide layer, a titanium oxide layer, or an aluminum oxide layer.

A first gate metal layer including gate electrodes TG of the thin-film transistors TFT, first capacitor electrodes CAE1 of the capacitors Cst, and scan lines may be located on the gate insulating layer 130. The gate electrode TG of each thin-film transistor TFT may overlap the channel region TCH in the third direction (Z-axis direction). The first gate metal layer may be a single layer or a multilayer including any one or more of molybdenum (Mo), aluminum (Al), chromium (Cr), gold (Au), titanium (Ti), nickel (Ni), neodymium (Nd), copper (Cu), or any alloys thereof.

The first interlayer insulating layer 141 may be located on the first gate metal layer. The first interlayer insulating layer 141 may include an inorganic layer, for example, a silicon nitride layer, a silicon oxynitride layer, a silicon oxide layer, a titanium oxide layer, or an aluminum oxide layer. The first interlayer insulating layer 141 may include a plurality of inorganic layers.

A second gate metal layer including second capacitor electrodes CAE2 of the capacitors Cst may be located on the first interlayer insulating layer 141. The second capacitor electrodes CAE2 may overlap the first capacitor electrodes CAE1 in the third direction (Z-axis direction). Therefore, the first capacitor electrodes CAE1, the second capacitor electrodes CAE2, and an inorganic insulating dielectric layer located between the first and second capacitor electrodes CAE1 and CAE2 to serve as a dielectric layer may form (e.g., at least partially define) the capacitors Cst. The second gate metal layer may be a single layer or a multilayer including any one or more of molybdenum (Mo), aluminum (Al), chromium (Cr), gold (Au), titanium (Ti), nickel (Ni), neodymium (Nd), copper (Cu), and alloys thereof.

The second interlayer insulating layer 142 may be located on the second gate metal layer. The second interlayer insulating layer 142 may include an inorganic layer, for example, a silicon nitride layer, a silicon oxynitride layer, a silicon oxide layer, a titanium oxide layer, or an aluminum oxide layer. The second interlayer insulating layer 142 may include a plurality of inorganic layers.

The first data metal layer including first connection electrodes CE1 and data lines may be located on the second interlayer insulating layer 142. The first connection electrodes CE1 may be connected to the drain regions TD through first contact holes CT1 penetrating the gate insulating layer 130, the first interlayer insulating layer 141, and the second interlayer insulating layer 142. The first data metal layer may be a single layer or a multilayer including any one or more of molybdenum (Mo), aluminum (Al), chromium (Cr), gold (Au), titanium (Ti), nickel (Ni), neodymium (Nd), copper (Cu), or any alloys thereof.

The first organic layer 160 may be located on the first connection electrodes CE1 to flatten steps caused by the thin-film transistors TFT. The first organic layer 160 may include an organic layer such as acryl resin, epoxy resin, phenolic resin, polyamide resin, or polyimide resin.

The second data metal layer including second connection electrodes CE2 may be located on the first organic layer 160. The second data metal layer may be connected to the first connection electrodes CE1 through second contact holes CT2 penetrating the first organic layer 160. The second data metal layer may be a single layer or a multilayer including any one or more of molybdenum (Mo), aluminum (Al), chromium (Cr), gold (Au), titanium (Ti), nickel (Ni), neodymium (Nd), copper (Cu), or any alloys thereof.

The second organic layer 180 may be located on the second connection electrodes CE2. The second organic layer 180 may include an organic layer such as acryl resin, epoxy resin, phenolic resin, polyamide resin, or polyimide resin.

The second data metal layer including the second connection electrodes CE2 and the second organic layer 180 can be omitted.

The light emitting element layer EML is located on the thin-film transistor layer TFTL. The light emitting element layer EML may include the light emitting elements LEL and a pixel defining layer 190.

Each of the light emitting elements LEL may include a pixel electrode 171, a light emitting layer 172, and a common electrode 173. Each emission area EA refers to an area in which the pixel electrode 171, the light emitting layer 172, and the common electrode 173 are sequentially stacked so that holes from the pixel electrode 171 and electrons from the common electrode 173 are combined with each other in the light emitting layer 172 to emit light. In this case, the pixel electrode 171 may be an anode, and the common electrode 173 may be a cathode.

A pixel electrode layer including the pixel electrodes 171 may be formed on the second organic layer 180. The pixel electrodes 171 may be connected to the second connection electrodes CE2 through third contact holes CT3 penetrating the second organic layer 180. The pixel electrode layer may be a single layer or a multilayer including any one or more of molybdenum (Mo), aluminum (Al), chromium (Cr), gold (Au), titanium (Ti), nickel (Ni), neodymium (Nd), copper (Cu), or any alloys thereof.

In a top emission structure in which light is emitted in a direction from the light emitting layers 172 toward the common electrode 173, each of the pixel electrodes 171 may be formed as a single layer of molybdenum (Mo), titanium (Ti), copper (Cu) or aluminum (Al) or, in order to increase reflectivity, may be formed as a stacked structure (Ti/Al/Ti) of aluminum and titanium, a stacked structure (ITO/Al/ITO) of aluminum and indium tin oxide, an APC alloy, or a stacked structure (ITO/APC/ITO) of an APC alloy and indium tin oxide. The APC alloy is an alloy of silver (Ag), palladium (Pd), and copper (Cu).

The pixel defining layer 190 defines the emission areas EA of pixels. To this end, the pixel defining layer 190 may be formed on the second organic layer 180 to partially expose the pixel electrodes 171. The pixel defining layer 190 may cover edges of the pixel electrodes 171. The pixel defining layer 190 may be located in the third contact holes CT3. That is, the third contact holes CT3 may be filled with the pixel defining layer 190. The pixel defining layer 190 may include an organic layer such as acryl resin, epoxy resin, phenolic resin, polyamide resin, or polyimide resin.

A spacer 191 may be located on the pixel defining layer 190. The spacer 191 may support a mask during a process of forming the light emitting layers 172. The spacer 191 may include an organic layer such as acryl resin, epoxy resin, phenolic resin, polyamide resin, or polyimide resin.

The light emitting layers 172 are formed on the pixel electrodes 171. The light emitting layers 172 may include an organic material to emit light of a selected color. For example, each of the light emitting layers 172 may include a hole transporting layer, an organic material layer, and an electron transporting layer. The organic material layer may include a host and a dopant. The organic material layer may include a material that emits selected light and may be formed using a phosphorescent material or a fluorescent material.

The common electrode 173 is formed on the light emitting layers 172. The common electrode 173 may be formed to cover the light emitting layers 172. The common electrode 173 may be a common layer formed in common in the emission areas EA. A capping layer may be formed on the common electrode 173.

In the top emission structure, the common electrode 173 may include a transparent conductive material (TCO) that can transmit light, such as indium tin oxide (ITO) or indium zinc oxide (IZO), or may include a semi-transmissive conductive material such as magnesium (Mg), silver (Ag), or an alloy of Mg and Ag. When the common electrode 173 includes a semi-transmissive conductive material, light output efficiency may be increased by a microcavity.

The encapsulation layer ENC may be located on the light emitting element layer EML. The encapsulation layer ENC may include at least one inorganic layer TFEl and TFE3 to prevent oxygen or moisture from penetrating into the light emitting element layer EML, or to reduce or minimize such penetration. In addition, the encapsulation layer ENC may include at least one organic layer TFE2 to protect the light emitting element layer EML from foreign substances such as dust. For example, the encapsulation layer ENC may include a first encapsulating inorganic layer TFE1, an encapsulating organic layer TFE2, and a second encapsulating inorganic layer TFE3.

The first encapsulating inorganic layer TFEl may be located on the common electrode 173, the encapsulating organic layer TFE2 may be located on the first encapsulating inorganic layer TFE1, and the second encapsulating inorganic layer TFE3 may be located on the encapsulating organic layer TFE2. Each of the first encapsulating inorganic layer TFE1 and the second encapsulating inorganic layer TFE3 may be a multilayer in which one or more inorganic layers selected from a silicon nitride layer, a silicon oxynitride layer, a silicon oxide layer, a titanium oxide layer, and an aluminum oxide layer are alternately stacked. The encapsulating organic layer TFE2 may be an organic layer such as acryl resin, epoxy resin, phenolic resin, polyamide resin, or polyimide resin.

The sensor electrode layer SENL may be located on the encapsulation layer ENC. The sensor electrode layer SENL may include a second buffer layer BF2, first connection portions BE1, a first sensor insulating layer TINS1, sensor electrodes TE and RE, and a second sensor insulating layer TINS2.

The second buffer layer BF2 may be located on the encapsulation layer ENC. The second buffer layer BF2 may include at least one inorganic layer. For example, the second buffer layer BF2 may be a multilayer in which one or more inorganic layers selected from a silicon nitride layer, a silicon oxynitride layer, a silicon oxide layer, a titanium oxide layer, and an aluminum oxide layer are alternately stacked. The second buffer layer BF2 can be omitted.

The first connection portions BE1 may be located on the second buffer layer BF2. Each of the first connection portions BE1 may be formed as a single layer of molybdenum (Mo), titanium (Ti), copper (Cu) or aluminum (Al) or may be formed as a stacked structure (Ti/Al/Ti) of aluminum and titanium, a stacked structure (ITO/Al/ITO) of aluminum and indium tin oxide, an APC alloy, or a stacked structure (ITO/APC/ITO) of an APC alloy and indium tin oxide.

The first sensor insulating layer TINS1 may be located on the first connection portions BE1. The first sensor insulating layer TINS1 may include an inorganic layer, for example, a silicon nitride layer, a silicon oxynitride layer, a silicon oxide layer, a titanium oxide layer, or an aluminum oxide layer.

The sensor electrodes, that is, driving electrodes TE and sensing electrodes RE may be located on the first sensor insulating layer TINS1. In addition, dummy patterns may be located on the first sensor insulating layer TINS1. The driving electrodes TE, the sensing electrodes RE, and the dummy patterns do not overlap the emission areas EA (e.g., do not overlap the emission areas EA in the third direction or Z-axis direction). Each of the driving electrodes TE, the sensing electrodes RE, and the dummy patterns may be formed as a single layer of molybdenum (Mo), titanium (Ti), copper (Cu) or aluminum (Al) or may be formed as a stacked structure (Ti/Al/Ti) of aluminum and titanium, a stacked structure (ITO/Al/ITO) of aluminum and indium tin oxide, an APC alloy, or a stacked structure (ITO/APC/ITO) of an APC alloy and indium tin oxide.

The second sensor insulating layer TINS2 may be located on the driving electrodes TE, the sensing electrodes RE, and the dummy patterns. The second sensor insulating layer TINS2 may include at least one of an inorganic layer and an organic layer. The inorganic layer may be a silicon nitride layer, a silicon oxynitride layer, a silicon oxide layer, a titanium oxide layer, or an aluminum oxide layer. The organic layer may be acryl resin, epoxy resin, phenolic resin, polyamide resin, or polyimide resin.

The polarizing film PF may be located on the sensor electrode layer SENL. The polarizing film PF may be located on the display panel 100 to reduce reflection of external light (e.g., light that is incident on the polarizing film PF from an ambient environment external to the display device 10). The polarizing film PF may include a first base member, a linear polarizer, a phase retardation film such as a λ/4 plate, and a second base member. The first base member, the phase retardation film, the linear polarizer, and the second base member of the polarizing film PF may be sequentially stacked on the display panel 100.

The cover window CW may be located on the polarizing film PF. The cover window CW may be attached onto the polarizing film PF by a transparent adhesive member such as an OCA film.

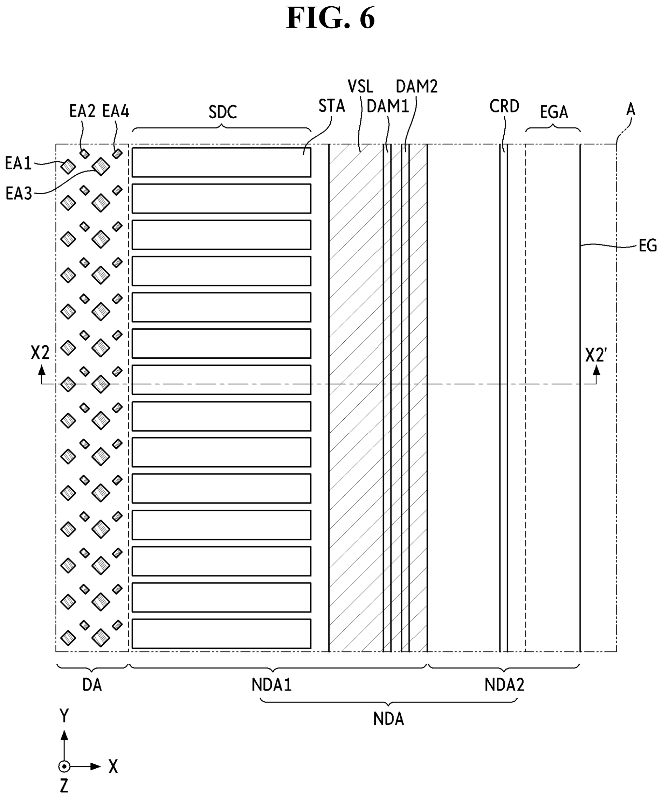

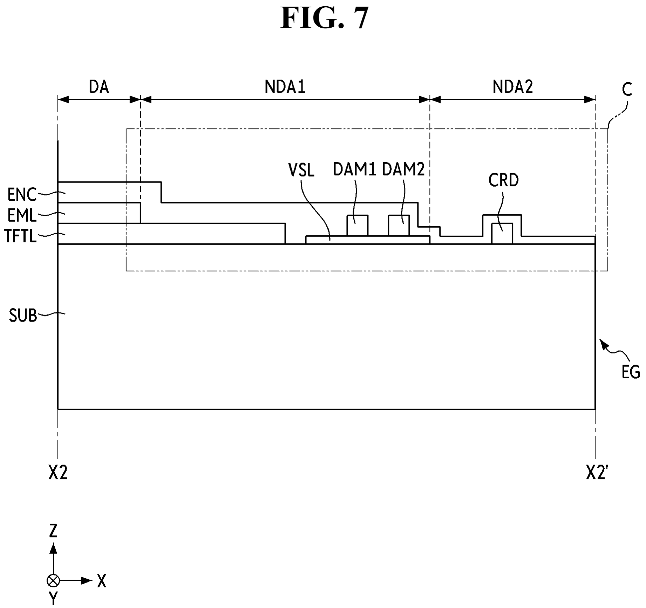

FIG. 6 is an enlarged view of area A of FIG. 2 according to some example embodiments. FIG. 7 is a cross-sectional view taken along line X2-X2' of FIG. 6 according to some example embodiments.

Referring to FIGS. 6 and 7 in addition to FIG. 5, the display area DA may include a plurality of emission areas EA1 through EA4. The emission areas EA1 through EA4 may include first emission areas EA1 which emit (e.g., are configured to emit) light of a first color, second emission areas EA2 and fourth emission areas EA4 which emit (e.g., are configured to emit) light of a second color, and third emission areas EA3 which emit (e.g., are configured to emit) light of a third color. For example, the light of the first color may be light in a red wavelength band of about 600 nm to about 750 nm, the light of the second color may be light in a green wavelength band of about 480 nm to about 560 nm, and the light of the third color may be light in a blue wavelength band of about 370 nm to about 460 nm. However, example embodiments of the present inventive concepts are not limited thereto.

Although example embodiments where the second emission areas EA2 and the fourth emission areas EA4 emit (e.g., are configured to emit) light of the same color, that is, light of the second color is illustrated in FIG. 6, example embodiments of the present inventive concepts are not limited thereto. The second emission areas EA2 and the fourth emission areas EA4 may also emit light of different colors. For example, the second emission areas EA2 may emit light of the second color, and the fourth emission areas EA4 may emit light of a fourth color.

In addition, although each of the first emission areas EA1, the second emission areas EA2, the third emission areas EA3, and the fourth emission areas EA4 has a rectangular planar shape in FIG. 6, example embodiments of the present inventive concepts are not limited thereto. Each of the first emission areas EA1, the second emission areas EA2, the third emission areas EA3, and the fourth emission areas EA4 may also have a polygonal shape other than a quadrangular shape, a circular shape, or an oval shape in plan view (e.g., in a plane extending in the first and second directions (e.g., X-axis and Y-axis directions) and/or a normal view of such plane).

In some example embodiments, the third emission areas EA3 may be the largest, and the second emission areas EA2 and the fourth emission areas EA4 may be the smallest. The second emission areas EA2 and the fourth emission areas EA4 may be the same size. However, example embodiments of the present inventive concepts are not limited thereto.

The second emission areas EA2 and the fourth emission areas EA4 may be alternately arranged in the first direction (X-axis direction). The second emission areas EA2 may be arranged in the second direction (Y-axis direction). The fourth emission areas EA4 may be arranged in the second direction (Y-axis direction).

The first emission areas EA1 and the third emission areas EA3 may be alternately arranged in the first direction (X-axis direction). The first emission areas EA1 may be arranged in the second direction (Y-axis direction). The third emission areas EA3 may be arranged in the second direction (Y-axis direction). Each of the first emission areas EA1 and the third emission areas EA3 may have a square planar shape, but example embodiments of the present inventive concepts are not limited thereto.

The non-display area NDA includes a first non-display area NDA1 and a second non-display area NDA2. The first non-display area NDA1 may be an area where structures for driving the pixels of the display area DA are located. The second non-display area NDA2 may be located outside the first non-display area NDA1, for example such that the second non-display area NDA2 may at least partially or entirely surround the first non-display area NDA1 in a plane extending in the first and second directions (X-axis and Y-axis directions). That is, the second non-display area NDA2 may be located closer to an edge EG of the display panel 100 than the first non-display area NDA1. The second non-display area NDA2 may be an outer area of the non-display area NDA. In addition, the second non-display area NDA2 may be an outer area of the display panel 100.

The first non-display area NDA1 may include a scan driving circuit unit SDC, a first power line VSL, a first dam DAM1, and a second dam DAM2.

The scan driving circuit unit SDC may include a plurality of stages STA. The stages STA may be respectively connected to scan lines SL of the display area DA which extend in the first direction (X-axis direction). That is, the stages STA may be connected one-to-one to the scan lines SL of the display area DA which extend in the first direction (X-axis direction). The stages STA may sequentially transmit scan signals to the scan lines SL.

The first power line VSL may be located outside the scan driving circuit unit SDC. That is, the first power line VSL may be located closer to an edge EG of the display panel 100 than the scan driving circuit unit SDC. The first power line VSL may extend in the second direction (Y-axis direction) in the non-display area NDA on a right side of the display panel 100.

The first power line VSL may be electrically connected to the common electrode 173. Accordingly, the common electrode 173 may receive a first power voltage from the first power line VSL.

The first dam DAM1 and the second dam DAM2 may be structures for preventing the encapsulating organic layer TFE2 of the encapsulation layer ENC from overflowing to the edge EG of the display panel 100, or reducing or minimizing such overflow.

The first dam DAM1 may surround the display area DA, and the second dam DAM2 may surround the first dam DAM1. For example, as illustrated in FIG. 6, the first dam DAM1 and the second dam DAM2 may extend in the second direction (Y-axis direction) in the non-display area NDA on the right side of the display panel 100. The second dam DAM2 may be located outside the first dam DAM1. Although not illustrated in the drawing, the first dam DAM1 and the second dam DAM2 may also be located in the non-display area NDA on upper, lower and left sides of the display panel 100. The first dam DAM1 and the second dam DAM2 may extend in the second direction (Y-axis direction) in the non-display area NDA on the left side of the display panel 100 and may extend in the first direction (X-axis direction) in the non-display area NDA on the upper and lower sides of the display panel 100.

The first dam DAM1 may be located closer to the scan driving circuit unit SDC than the second dam DAM2, and the second dam DAM2 may be located closer to the edge EG of the display panel 100 than the first dam DAM1.

Although the first dam DAM1 and the second dam DAM2 are located on the first power line VSL in FIG. 6, example embodiments of the present inventive concepts are not limited thereto. For example, any one of the first dam DAM1 or the second dam DAM2 may not be located on the first power line VSL. In some example embodiments, neither the first dam DAM1 nor the second dam DAM2 may be located on the first power line VSL. In some example embodiments, the first dam DAM1 and the second dam DAM2 may be located outside the first power line VSL.

In addition, although the display panel 100 according to some example embodiments includes two dams DAM1 and DAM2 in FIG. 6, example embodiments of the present inventive concepts are not limited thereto. That is, the display panel 100 according to some example embodiments may also include three or more dams.

In some example embodiments, the second non-display area NDA2 may include a crack dam CRD.

The crack dam CRD may be a structure for preventing cracks in inorganic layers of the encapsulation layer ENC from propagating in a process of cutting the substrate SUB during a process of manufacturing the display device 10, or reducing or minimizing such propagation. The crack dam CRD may be located in the second non-display area NDA2 and may be located outside the first dam DAM1 and the second dam DAM2. For example, the crack dam CRD may be located closer to the edge EG of the display panel 100 than the first dam DAM1 and the second dam DAM2.

The crack dam CRD may be located along left, upper, and right edges of the display panel 100. For example, as illustrated in FIG. 6, the crack dam CRD may extend in the second direction (Y-axis direction) in the non-display area NDA on the right side of the display panel 100. Although not illustrated in the drawing, the crack dam CRD may also be located in the non-display area NDA on the upper and left sides of the display panel 100. The crack dam CRD may extend in the second direction (Y-axis direction) in the non-display area NDA on the left side of the display panel 100 and may extend in the first direction (X-axis direction) in the non-display area NDA on the upper side of the display panel 100. The crack dam CRD may not be located on a lower edge of the display panel 100. However, example embodiments of the present inventive concepts are not limited thereto. In some example embodiments, the crack dam CRD may also be located in the non-display area NDA on the lower side of the display panel 100. In some example embodiments, the crack dam CRD may extend in the first direction (X-axis direction). In some example embodiments, the crack dam CRD may be an outermost structure located at an outermost position in the display panel 100.

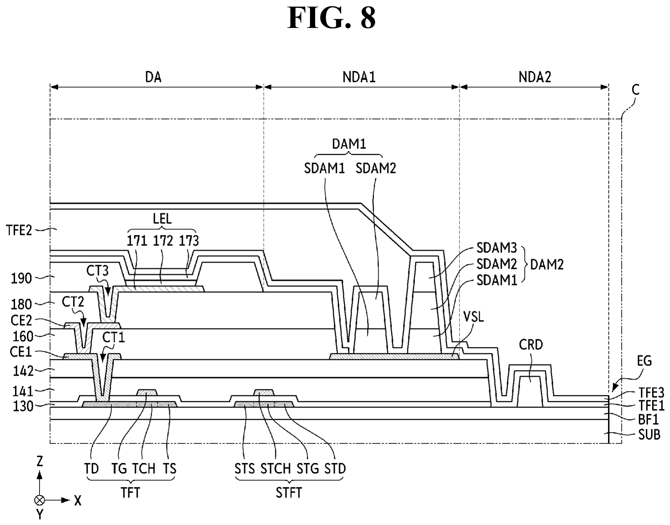

FIG. 8 is an enlarged view of area C of FIG. 7 according to some example embodiments.

Referring to FIG. 8, the first power line VSL may include the same material as the first data metal layer including the first connection electrodes CE1 and the data lines and may be located in the same layer as the first data metal layer. The first power line VSL may be located on the second interlayer insulating layer 142. The first power line VSL may be a single layer or a multilayer including any one or more of molybdenum (Mo), aluminum (Al), chromium (Cr), gold (Au), titanium (Ti), nickel (Ni), neodymium (Nd), copper (Cu), or any alloys thereof.

The first dam DAM1 and the second dam DAM2 may be located on the first power line VSL. The first dam DAM1 may include a first sub-dam SDAM1 and a second sub-dam SDAM2, and the second dam DAM2 may include a first sub-dam SDAM1, a second sub-dam SDAM2 and a third sub-dam SDAM3. The first sub-dam SDAM1 may include the same material as the first organic layer 160 and may be located in the same layer as the first organic layer 160. The second sub-dam SDAM2 may include the same material as the second organic layer 180 and may be located in the same layer as the second organic layer 180. The third sub-dam SDAM3 may include the same material as the pixel defining layer 190 and may be located in the same layer as the pixel defining layer 190.

A height of the first dam DAM1 may be lower than a height of the second dam DAM2. However, embodiments of the present specification are not limited thereto. The height of the first dam DAM1 may also be substantially equal to the height of the second dam DAM2 or may also be higher than the height of the second dam DAM2. As described herein, a "height" of an element may refer to a distance in the third direction or Z-axis direction of an upper surface of the element from a reference surface or structure such as the substrate SUB (e.g., wherein the upper surface of the element is a surface that is furthest from the reference surface or structure in the third direction or Z-axis direction).

The common electrode 173 may be connected to the first power line VSL exposed without being covered by the first organic layer 160, the second organic layer 180, and the first dam DAM1. Accordingly, the common electrode 173 may receive the first power voltage of the first power line VSL.

The first encapsulating inorganic layer TFEl may cover the first dam DAM1, the second dam DAM2, and the crack dam CRD in the non-display area NDA. However, embodiments of the present specification are not limited thereto. In some example embodiments, the first encapsulating inorganic layer TFE1 may not cover at least one of the second dam DAM2 and the crack dam CRD.

In some example embodiments, a side of the first encapsulating inorganic layer TFEl may be aligned with (e.g., may be flush and/or coplanar with) a side of the substrate SUB at the edge EG of the display panel 100. However, example embodiments of the present inventive concepts are not limited thereto.

The encapsulating organic layer TFE2 may cover an upper surface of the first dam DAM1 and may not cover an upper surface of the second dam DAM2. However, example embodiments of the present inventive concepts are not limited thereto. The encapsulating organic layer TFE2 may also not cover both the upper surface of the first dam DAM1 and the upper surface of the second dam DAM2. Due to the first dam DAM1 and the second dam DAM2, the encapsulating organic layer TFE2 may not overflow to the edge EG of the display panel 100, or any such overflow may be reduced or minimized.

The second encapsulating inorganic layer TFE3 may cover the first dam DAM1, the second dam DAM2, and the crack dam CRD in the non-display area NDA. However, example embodiments of the present inventive concepts are not limited thereto. In some example embodiments, the second encapsulating inorganic layer TFE3 may not cover (e.g., may at least partially expose in the third direction or Z-axis direction) at least one of the second dam DAM2 or the crack dam CRD.

In some example embodiments, a side of the encapsulating inorganic layer TFE2 may be aligned with (e.g., may be flush and/or coplanar with) the side of the substrate SUB at the edge EG of the display panel 100. However, example embodiments of the present inventive concepts are not limited thereto.

An inorganic encapsulation area in which the first encapsulating inorganic layer TFE1 and the second encapsulating inorganic layer TFE3 contact each other may be formed from the second dam DAM2 to the edge EG of the display panel 100. The inorganic encapsulation area may surround the second dam DAM2.

A scan thin-film transistor STFT of the scan driving circuit unit SDC is illustrated in FIG. 8. Since the scan thin-film transistor STFT is substantially the same as the thin-film transistors TFT described with reference to FIG. 5, a description of the scan thin-film transistor STFT is omitted.

The crack dam CRD may include the same material as the first organic layer 160. The crack dam CRD may be located on the first buffer layer BF1. The crack dam CRD may include an organic layer such as acryl resin, epoxy resin, phenolic resin, polyamide resin, or polyimide resin.

Although the crack dam CRD includes one organic layer in FIG. 8, example embodiments of the present inventive concepts are not limited thereto. For example, the crack dam CRD may further include another organic layer including the same material as the second organic layer 180. In some example embodiments, the crack dam CRD may further include another organic layer including the same material as the pixel defining layer 190. In some example embodiments, the crack dam CRD may further include another organic layer including the same material as the spacer 191 (see FIG. 5).

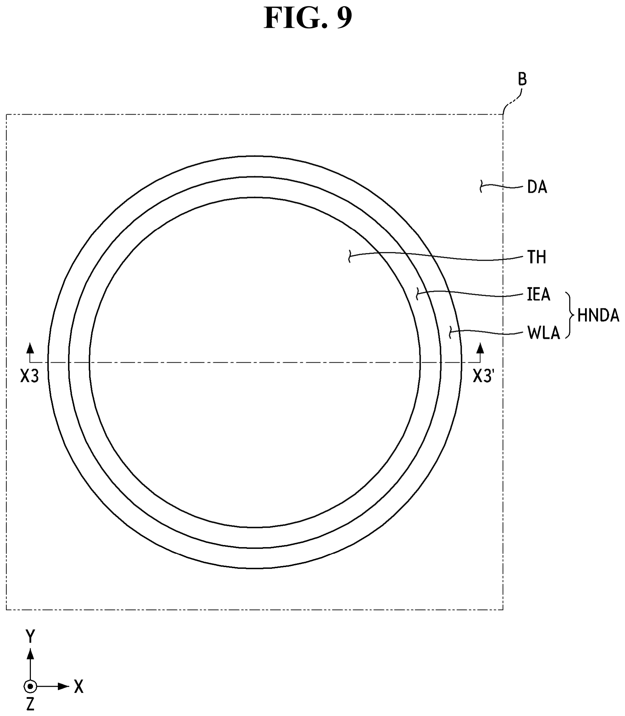

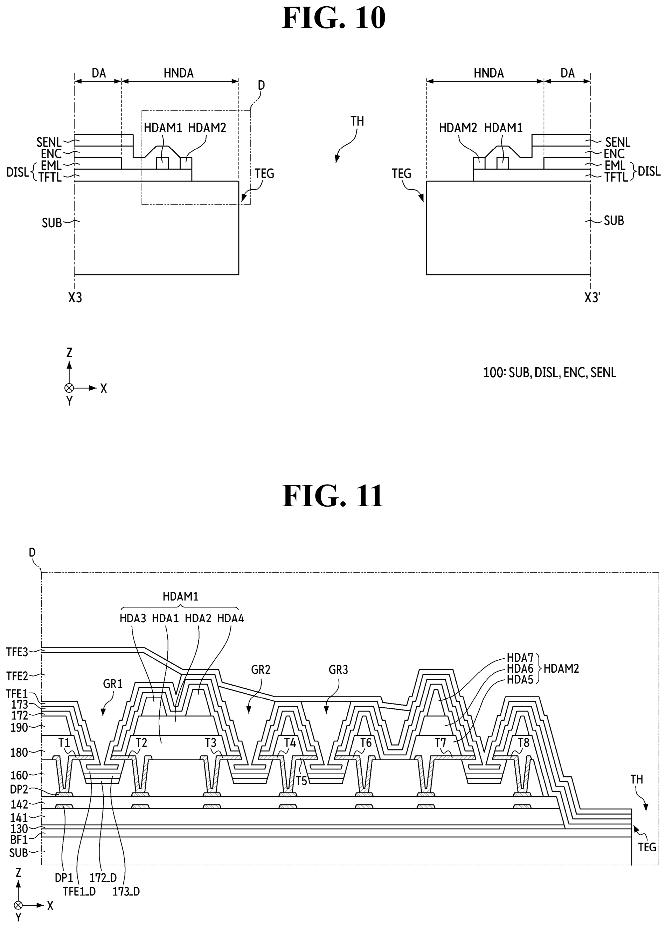

FIG. 9 is an enlarged view of area B of FIG. 2 according to some example embodiments. FIG. 10 is a cross-sectional view taken along line X3-X3' of FIG. 9 according to some example embodiments. FIG. 11 is an enlarged view of area D of FIG. 10 according to some example embodiments.

Referring to FIGS. 9 through 11, the display panel 100 according to some example embodiments may include a hole non-display area HNDA surrounding the through hole TH. The hole non-display area HNDA may include an inorganic encapsulation area IEA and a wiring area WLA surrounding the inorganic encapsulation area IEA.

The inorganic encapsulation area IEA may be a layer where the first encapsulating inorganic layer TFE1 and the second encapsulating inorganic layer TFE3 of the encapsulation layer ENC contact each other to prevent penetration of oxygen or moisture into the light emitting element layer EML of the display layer DISL due to the through hole TH, or to reduce or minimize such penetration.

The inorganic encapsulation area IEA may include at least one dam, at least one tip, and at least one groove. For example, as illustrated in FIG. 11, the inorganic encapsulation area IEA may include a first hole dam HDAM1, a second hole dam HDAM2, first through eighth tips T1 through T8, and first through third grooves GR1 through GR3.

The first tip T1 and the second tip T2 may be located closer to the wiring area WLA than the first hole dam HDAM1. The first tip T1 may be located closer to the wiring area WLA than the second tip T2. The second tip T2 may be located between the first tip T1 and the first hole dam HDAM1.

The third tip T3, the fourth tip T4, the fifth tip T5, and the sixth tip T6 may be located between the first hole dam HDAM1 and the second hole dam HDAM2. At least a portion of the third tip T3 may overlap the first hole dam HDAM1 in the third direction (Z-axis direction).

The seventh tip T7 and the eighth tip T8 may be located closer to the through hole TH than the second hole dam HDAM2. At least a portion of the seventh tip T7 may overlap the second hole dam HDAM2 in the third direction (Z-axis direction). The eighth tip T8 may be located between the second hole dam HDAM2 and the through hole TH.

The first groove GR1 may be located between the first tip T1 and the second tip T2. The second groove GR2 may be located between the third tip T3 and the fourth tip T4. The third groove GR3 may be located between the fifth tip T5 and the sixth tip T6.

The wiring area WLA may be an area where bypass lines due to the through hole TH are located. Some of the bypass lines may be connected to data lines, and some other ones of the bypass lines may be connected to a second power line to which a second power voltage higher than the first power voltage is applied. Some other ones of the bypass lines may be connected to scan lines. The wiring area WLA may be surrounded by the display area DA.

First dummy patterns DP1 may include the same material as the second gate metal layer including the second capacitor electrodes CAE2 of the capacitors Cst and may be located in the same layer as the second gate metal layer. For example, the first dummy patterns DP1 may be located on the first interlayer insulating layer 141. Each of the first dummy patterns DP1 may be a single layer or a multilayer including any one or more of molybdenum (Mo), aluminum (Al), chromium (Cr), gold (Au), titanium (Ti), nickel (Ni), neodymium (Nd), copper (Cu), or any alloys thereof.

Second dummy patterns DP2 may include the same material as the first data metal layer including the first connection electrodes CE1 and the data lines and may be located in the same layer as the first data metal layer. For example, the second dummy patterns DP2 may be located on the second interlayer insulating layer 142. Each of the second dummy patterns DP2 may be a single layer or a multilayer including any one or more of molybdenum (Mo), aluminum (Al), chromium (Cr), gold (Au), titanium (Ti), nickel (Ni), neodymium (Nd), copper (Cu), or any alloys thereof.

The second dummy patterns DP2 may overlap the first dummy patterns DP1 in the third direction (Z-axis direction).

The first through eighth tips T1 through T8 may include the same material as the second data metal layer including the second connection electrodes CE2 and may be located in the same layer as the second data metal layer. For example, the first through eighth tips T1 through T8 may be located on the first organic layer 160. Each of the first through eighth tips T1 through T8 may be a single layer or a multilayer including any one or more of molybdenum (Mo), aluminum (Al), chromium (Cr), gold (Au), titanium (Ti), nickel (Ni), neodymium (Nd), copper (Cu), and alloys thereof.

Each of the first through eighth tips T1 through T8 may be connected to a second dummy pattern DP2 through a contact hole penetrating the first organic layer 160. Each of the first through eighth tips T1 through T8 may have an eaves structure whose upper and lower surfaces are exposed without being covered by the first organic layer 160, the second organic layer 180, the first hole dam HDAM1, and the second hole dam HDAM2. The fourth tip T4 and the fifth tip T5 may be formed integrally with each other. Each of the first through eighth tips T1 through T8 may be a protrusion pattern or a trench pattern for forming a groove (or a trench). A distance from the eighth tip T8 to an edge TEG of the through hole TH may be, but is not limited to, about 300 µm.

The first groove GR1 may be located between the first tip T1 and the second tip T2, the second groove GR2 may be located between the third tip T3 and the fourth tip T4, and the third groove GR3 may be located between the fifth tip T5 and the sixth tip T6. The first groove GR1 may have eaves structures formed by the first tip T1 and the second tip T2, the second groove GR2 may have eaves structures formed by the third tip T3 and the fourth tip T4, and the third groove GR3 may have eaves structures formed by the fifth tip T5 and the sixth tip T6.

In some example embodiments, the light emitting layer 172 is deposited based on evaporation, and the common electrode 173 is deposited based on sputtering. Therefore, the light emitting layer 172 and the common electrode 173 may have low step coverage and thus may be broken in each of the first through third grooves GR1 through GR3. In some example embodiments, the first encapsulating inorganic layer TFE1 and the third encapsulating inorganic layer TFE3 are deposited based on chemical vapor deposition or atomic layer deposition. Therefore, the first encapsulating inorganic layer TFE1 and the third encapsulating inorganic layer TFE3 may have high step coverage and thus may be continuous without being broken in each of the first through third grooves GR1 through GR3. For example, a light emitting layer fragment 172_D broken off from the light emitting layer 172 and a common electrode fragment 173_D broken off from the common electrode 173 may be located in each of the first through third grooves GR1 through GR3. The step coverage refers to the ratio of the degree of thin-film coating on an inclined portion to the degree of thin-film coating on a flat portion.

The first dam HDAM1 may include first through fourth hole sub-dams HDA1 through HDA4. The first hole sub-dam HDA1 may be located on the first organic layer 160 and may include the same material as the second organic layer 180. The first hole sub-dam HDA1 may be located on the second tip T2 and the third tip T3. The second hole sub-dam HDA2 may be located on the first hole sub-dam HDA1 and may include the same material as the pixel defining layer 190. The third hole sub-dam HDA3 and the fourth hole sub-dam HDA4 may be located on the second hole sub-dam HDA2 and may include the same material as the spacer 191, but example embodiments of the present inventive concepts are not limited thereto. The fourth hole sub-dam HDA4 may be located closer to the through hole TH than the third hole sub-dam HDA3. A thickness of the fourth hole sub-dam HDA4 may be greater than that of the third hole sub-dam HDA3.

The second hole dam HDAM2 may include fifth through seventh hole sub-dams HDA5 through HDA7. The fifth hole sub-dam HDA5 may be located on the first organic layer 160 and may include the same material as the second organic layer 180. The fifth hole sub-dam HDA5 may be located on the seventh tip T7. The sixth hole sub-dam HDA6 may be located on the fifth hole sub-dam HDA5 and may include the same material as the pixel defining layer 190. The seventh hole sub-dam HDA7 may be located on the sixth hole sub-dam HDA6 and may include the same material as the spacer 191, but example embodiments of the present inventive concepts are not limited thereto.

The first hole dam HDAM1 and the second hole dam HDAM2 may prevent the encapsulating organic layer TFE2 from overflowing to the through hole TH, or may reduce or minimize such overflow.

The light emitting layer 172, the common electrode 173, the first encapsulating inorganic layer TFE1, and the second encapsulating inorganic layer TFE3 may extend to the edge TEG of the through hole TH. An end of the light emitting layer 172, an end of the common electrode 173, an end of the first encapsulating inorganic layer TFE1, or an end of the second encapsulating inorganic layer TFE3 may match and/or may at least partially define the edge TEG of the through hole TH. However, example embodiments of the present inventive concepts are not limited thereto, and the end of the light emitting layer 172, the end of the common electrode 173, the end of the first encapsulating inorganic layer TFE1, or the end of the second encapsulating inorganic layer TFE3 may also not match the edge TEG of the through hole TH.

As illustrated in FIG. 11, since the light emitting layer 172 and the common electrode 173 are broken in each of the first through third grooves GR1 through GR3 formed by the first through eighth tips T1 through T8, it is possible to prevent the light emitting layer 172 and the common electrode 173 exposed to the through hole TH from serving as and/or defining a path through which oxygen and moisture are introduced, or reduce or minimize such path.

Referring again to FIG. 7, a process of cutting the substrate SUB of the display panel 100 by spraying an etchant after irradiating a laser beam may be performed in order to reduce or minimize a distance (or a width of the second non-display area NDA2) from the crack dam CRD to the edge EG of the display panel 100. When the substrate SUB of the display panel 100 is cut based on spraying the etchant after irradiating the laser beam, the width of the second non-display area NDA2 (e.g., in the first and/or second directions) may be significantly reduced. That is, a width of the non-display area NDA can be reduced or minimized. As a result, the display device 10 may have an increase ratio of display area DA to non-display area NDA and thus may exhibit increased immersion in the display area and enhanced aesthetic appearance.

Similarly, referring again to FIG. 10, a process of forming the through hole TH based on spraying an etchant after irradiating a laser beam may be performed in order to reduce or minimize a distance (or a width of the hole non-display area HNDA) from the second hole dam HDAM2 to the edge TEG of the through hole TH. When the through hole TH is formed based on spraying the etchant after irradiating the laser beam, the width of the hole non-display area HNDA may be significantly reduced. That is, the width of the hole non-display area HNDA (e.g., the width in the first and/or second directions) can be reduced or minimized. As a result, the display device 10 may have an increase ratio of display area DA to hole non-display area HNDA and thus may exhibit increased immersion in the display area and enhanced aesthetic appearance.

A method of manufacturing a display device according to some example embodiments by cutting the substrate SUB and forming the through hole TH by spraying an etchant after irradiating a laser beam will now be described.

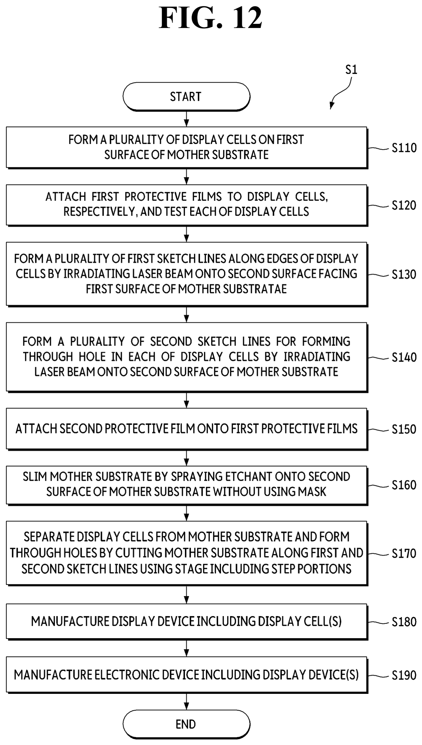

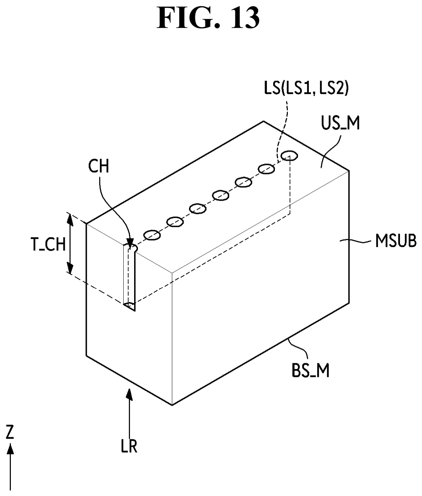

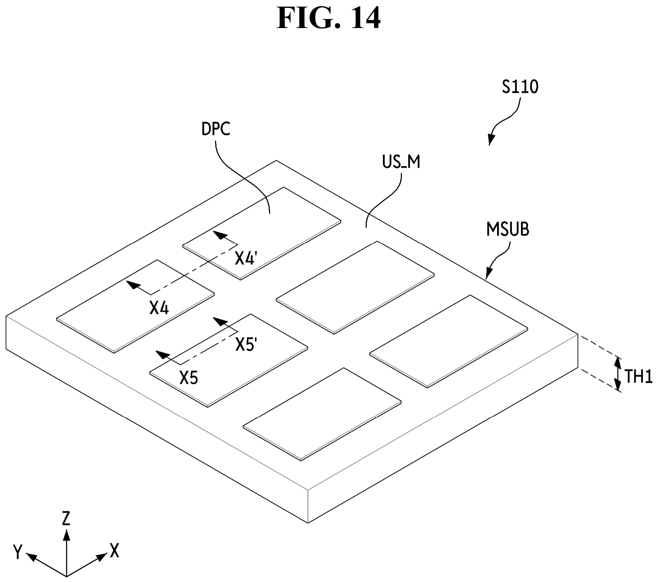

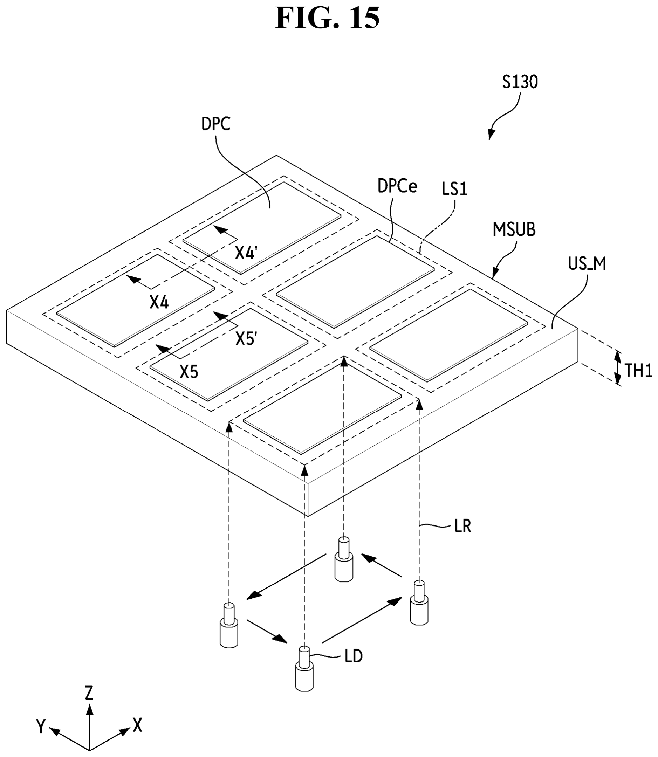

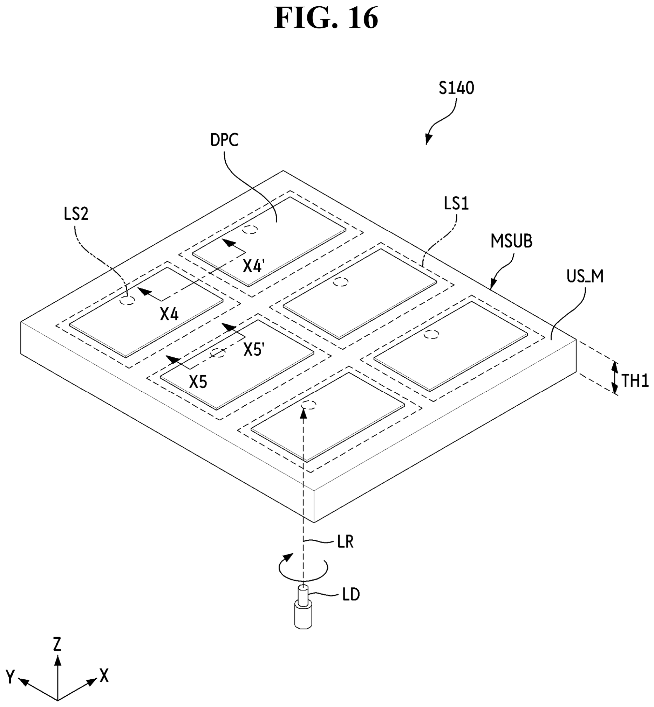

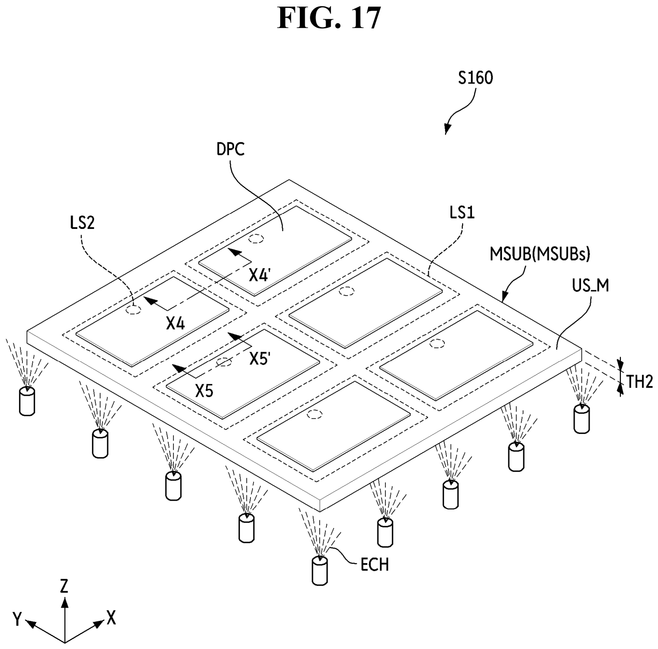

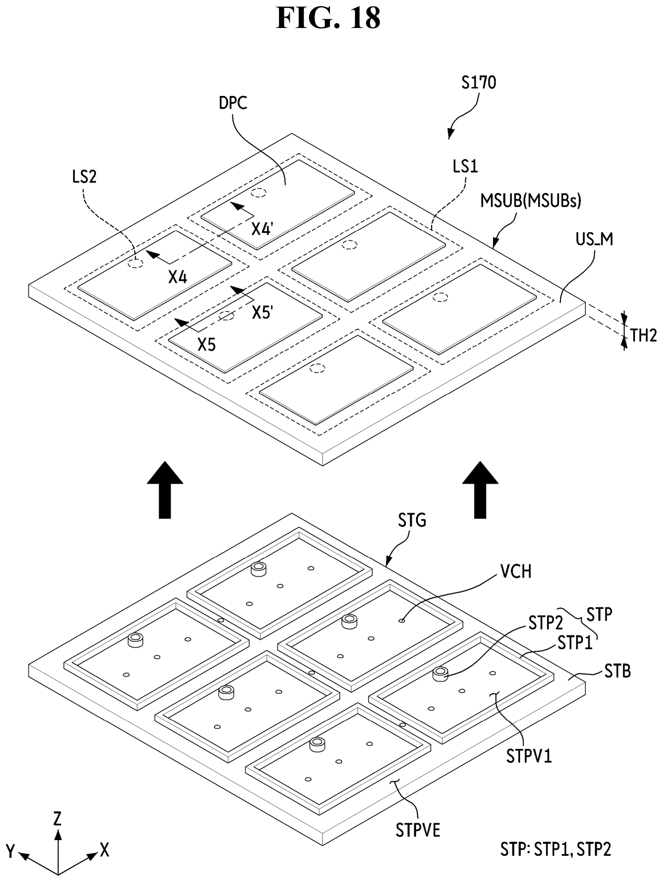

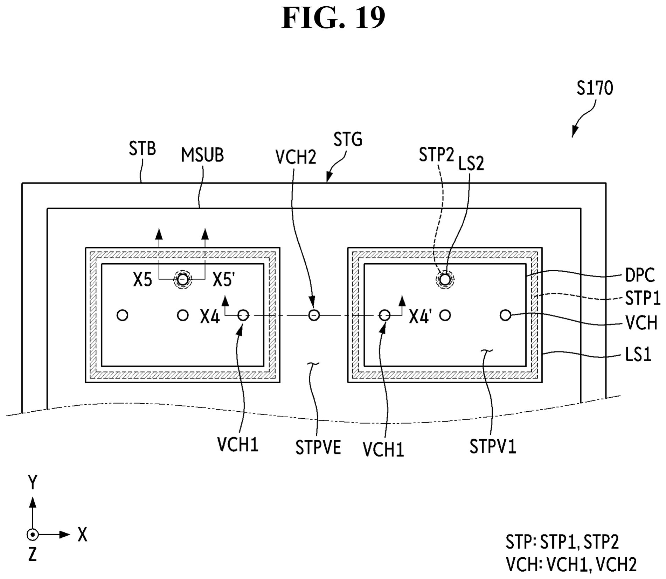

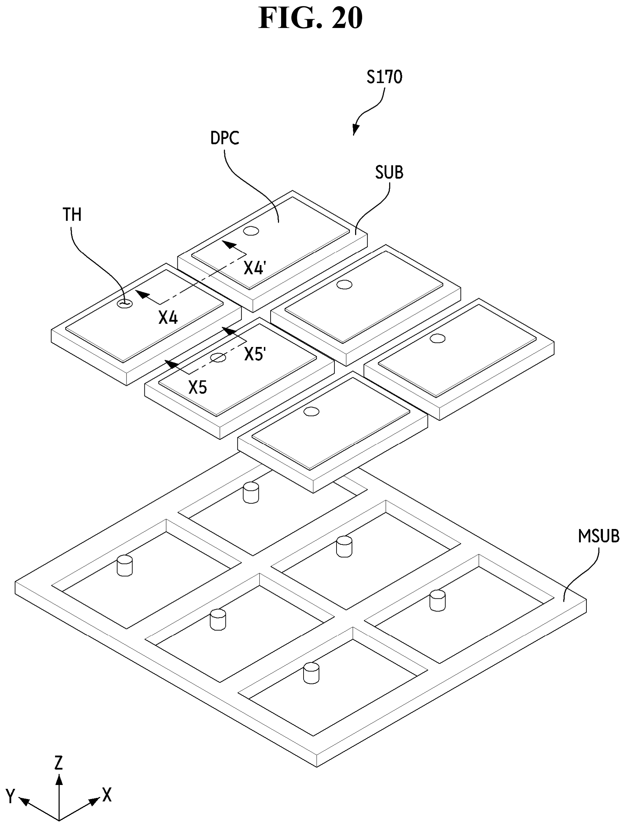

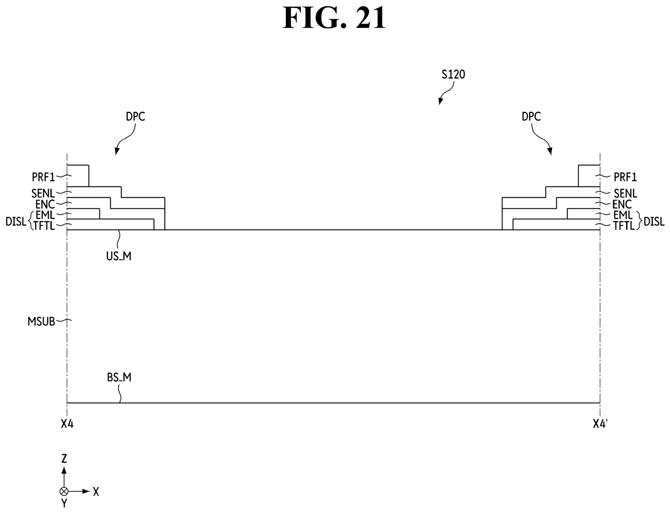

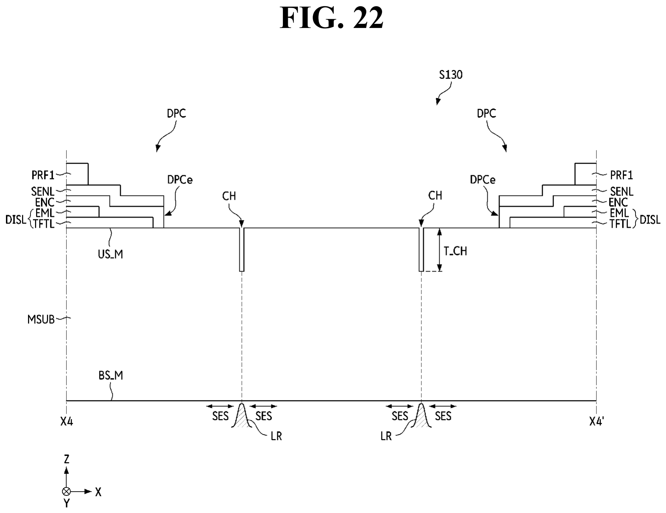

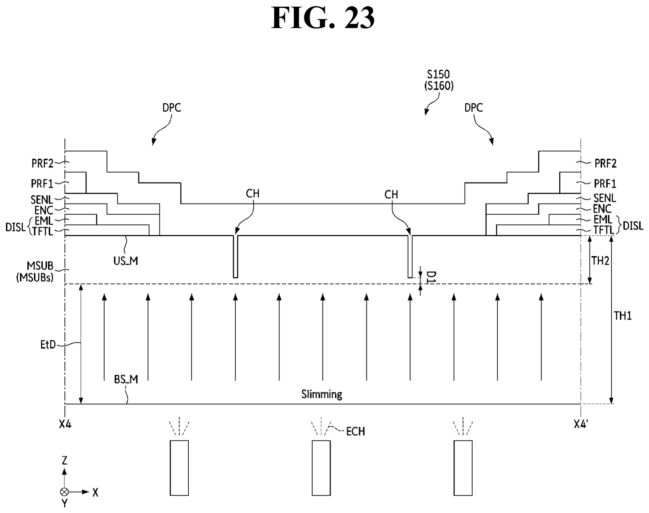

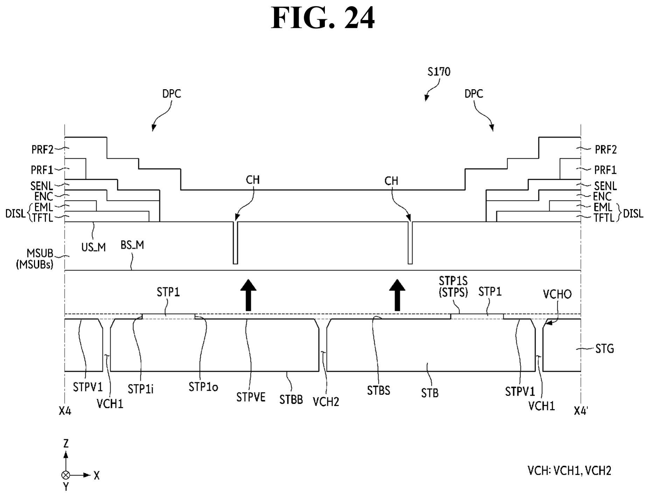

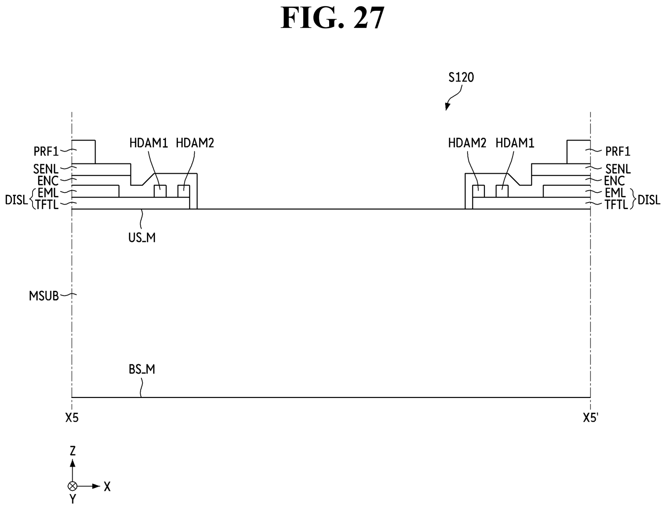

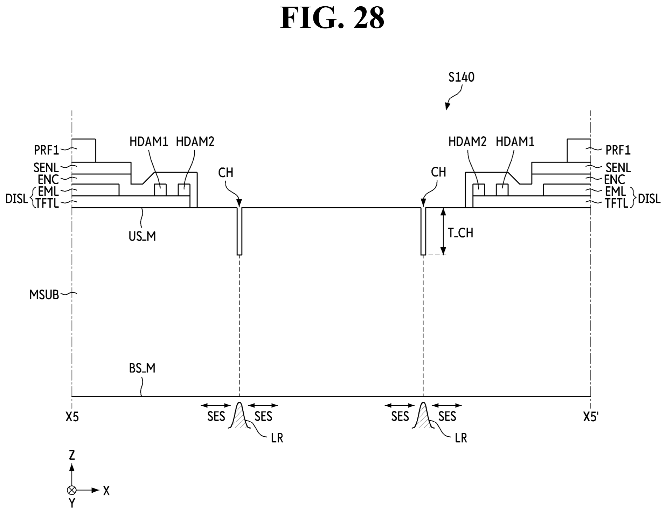

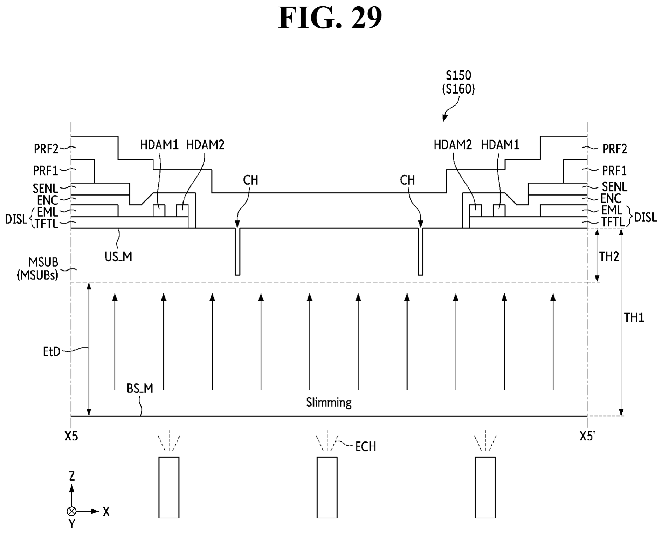

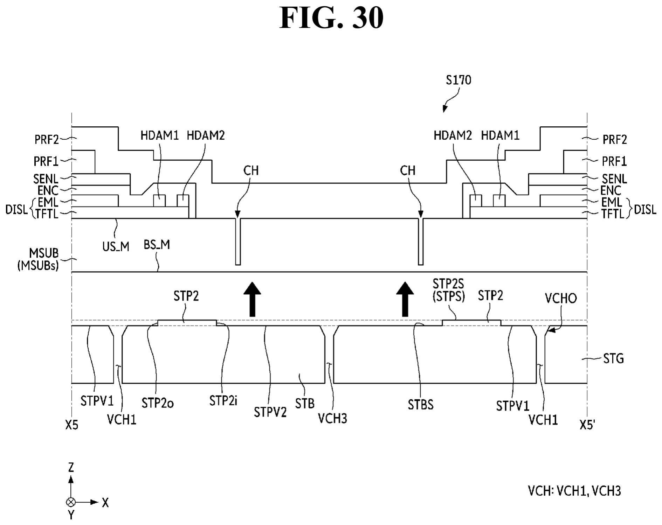

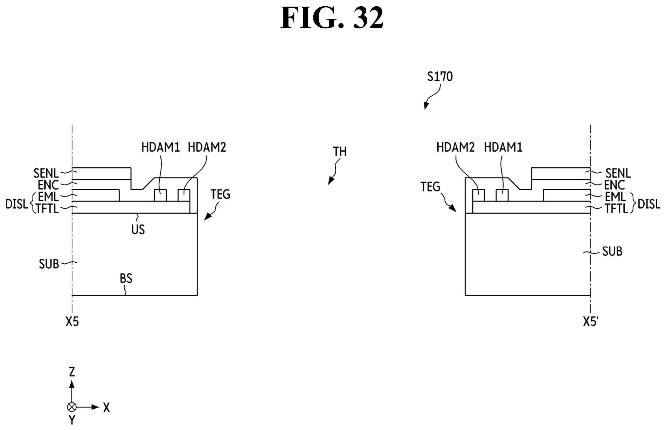

FIG. 12 is a flowchart illustrating a method of manufacturing a display device according to some example embodiments. FIG. 13 is an example view illustrating depths of laser irradiation areas formed by a laser processing apparatus according to some example embodiments. FIG. 14 is a perspective view illustrating operation S110 of FIG. 12 according to some example embodiments. FIG. 15 is a perspective view illustrating operation S130 of FIG. 12 according to some example embodiments. FIG. 16 is a perspective view illustrating operation S140 of FIG. 12 according to some example embodiments. FIG. 17 is a perspective view illustrating operation S160 of FIG. 12 according to some example embodiments. FIG. 18 is a perspective view illustrating operation S170 of FIG. 12 according to some example embodiments. FIG. 19 is a plan view illustrating operation S170 of FIG. 12 according to some example embodiments. FIG. 20 is a perspective view illustrating operation S170 of FIG. 12 according to some example embodiments. FIG. 21 is a cross-sectional view illustrating operation S120 of FIG. 12 according to some example embodiments. FIG. 22 is a cross-sectional view illustrating operation S130 of FIG. 12 according to some example embodiments. FIG. 23 is a cross-sectional view illustrating operation S160 of FIG. 12 according to some example embodiments. FIGS. 24, 25, and 26 are cross-sectional views illustrating operation S170 of FIG. 12 according to some example embodiments. FIG. 27 is a cross-sectional view illustrating operation S120 of FIG. 12 according to some example embodiments. FIG. 28 is a cross-sectional view illustrating operation S140 of FIG. 12. FIG. 29 is a cross-sectional view illustrating operation S160 of FIG. 12 according to some example embodiments. FIGS. 30, 31, and 32 are cross-sectional views illustrating operation S170 of FIG. 12 according to some example embodiments.

It will be understood that the order of operations of the method S1 shown in FIG. 12 may be rearranged and/or performed in any order, including a different order than shown in FIG. 12. Any of the operations shown in FIG. 12 may be omitted from the method S1. One or more operations not shown in FIG. 12 may be added to the method S1.

Referring to FIGS. 12 through 32, in the method S1 of manufacturing the display device according to some example embodiments, first, a plurality of display cells DPC are formed on a first surface US_M of a mother substrate MSUB as illustrated in FIG. 14 (operation S110 in FIG. 12).

Second, as illustrated in FIGS. 21 and 27, a plurality of first protective films PRF1 are attached onto the display cells DPC, and the display cells DPC are tested (operation S120 in FIG. 12).

For example, a first protective film layer may be attached to cover the display cells DPC and the mother substrate MSUB located between the display cells DPC. Then, the first protective film layer located on the mother substrate MSUB is partially removed to form the first protective films PRF1 on the display cells DPC, respectively. That is, portions remaining after the first protective film layer is partially removed may be the first protective films PRF1. Therefore, the first protective films PRF1 may be located on the display cells DPC, respectively. That is, the first protective films PRF1 may be located to correspond one-to-one to the display cells DPC.

The first protective films PRF1 may be buffer films for protecting the display cells DPC from external impact, respectively. The first protective films PRF1 may include a transparent material.

Next, the display cells DPC are tested using a test device. After a probe is connected to a plurality of test pads provided in the display cells DPC, respectively, a lighting test of each of the display cells DPC may be performed.

If the lighting test is performed after the display cells DPC are separated from the mother substrate MSUB by a cutting process, an additional process is required to remove the test pads after the completion of the lighting test. On the other hand, if the lighting test is performed in a state where the display cells DPC are located on the mother substrate MSUB, the test pads are removed later when the display cells DPC are separated from the mother substrate MSUB through laser irradiation and etching. Therefore, if the lighting test is performed in a state where the display cells DPC are located on the mother substrate MSUB, an additional process for removing the test pads is not required, thereby reducing manufacturing costs and complexity.

Third, as illustrated in FIGS. 15 and 22 (and in view of FIG. 13), a plurality of first sketch lines LS1 are formed along edges of the display cells DPC by irradiating a laser beam LR (e.g., a first laser beam) onto a second surface BS_M of the mother substrate MSUB which faces (e.g., is opposite to) the first surface US_M (operation S130 in FIG. 12), for example such that at least a portion of the second surface BS_M is irradiated by the laser beam LR.

Various laser beams may be used as the laser beam LR according to some example embodiments. However, in the present specification, a case where the laser beam LR is an infrared Bessel beam having a wavelength of about 1030 nm is described as an example.

As illustrated in FIGS. 15 and 22, the laser beam LR may be irradiated onto the second surface BS_M of the mother substrate MSUB. However, example embodiments of the present inventive concepts are not limited thereto. The laser beam LR may also or alternatively be irradiated onto the first surface US_M of the mother substrate MSUB.

Each of the first sketch lines LS1 may be defined as a virtual line connecting laser irradiation areas CH surrounding, in a plan view (e.g., in a plane extending parallel to the first surface US_M of the mother substrate MSUB, in a plane extending in the first and second directions (XY plane), and/or in a normal view of such one or more planes), a given display cell DPC that is on the mother substrate MSUB. Accordingly, the plurality of first sketch lines LS1 formed at S130 may be understood to surround, in the plan view, separate, respective display cells DPC on the mother substrate MSUB. Each of the first sketch lines LS1 may be formed by forming the laser irradiation areas CH along edges of a display cell DPC by irradiating the laser beam LR onto the second surface BS_M and/or the first surface US_M of the mother substrate MSUB, such that the first sketch line LS1 extends along the edges of the display cell DPC.

A unilateral tolerance SES of the laser beam LR may be within about 50 µm, and a bilateral tolerance of the laser beam LR may be within about 100 µm. The unilateral tolerance SES of the laser beam LR may be a cutting error in one direction (e.g., the X-axis direction or the Y-axis direction) when the first sketch lines LS1 are formed using the laser beam LR.

Fourth, as illustrated in FIGS. 16 and 28 (and in view of FIG., 13), a plurality of second sketch lines LS2 for forming a through hole TH in each of the display cells DPC are formed by irradiating a laser beam LR (e.g., a second laser beam, which may be the same or different as the first laser beam LR) onto the second surface BS_M of the mother substrate MSUB (operation S140 in FIG. 12).

Although operation S140 is performed after operation S130 in FIG. 12, example embodiments of the present inventive concepts are not limited thereto. To reduce the process time, operations S130 and S140 may also be performed simultaneously using a plurality of laser processing apparatuses LD. In some example embodiments, operation S130 may be performed after operation S140.

Each of the second sketch lines LS2 may be defined as a virtual line connecting laser irradiation areas CH defining an area, in a plan view (e.g., in a plane extending parallel to the first surface US_M of the mother substrate MSUB), that may be surrounded by an inorganic encapsulation area IEA and a wiring area WLA of the display cell DPC. Accordingly, the plurality of second sketch lines LS2 formed at S140 may be understood to define separate, respective areas, in a plan view, in separate, respective display cells DPC on the mother substrate MSUB. Each of the second sketch lines LS2 may be formed by forming the laser irradiation areas CH along edges of a through hole TH by irradiating the laser beam LR onto the second surface BS_M and/or the first surface US_M of the mother substrate MSUB, such that the first sketch line LS1 extends along the edges of the display cell DPC. Each of the second sketch lines LS2 may depend on the shape of the through hole TH. For example, when the through hole TH has a circular planar shape, each of the second sketch lines LS2 may be formed in a circular shape (e.g., may define a circular area in plan view). However, the shape of the through hole TH is not limited to a circular shape and can be variously changed, and accordingly the second sketch lines LS2 may each define a differently shaped area in the plan view that may or may not be circular.

A unilateral tolerance SES of the laser beam LR may be within about 50 µm, and a bilateral tolerance of the laser beam LR may be within about 100 µm. The unilateral tolerance SES of the laser beam LR may be a cutting error in one direction (e.g., the X-axis direction or the Y-axis direction) when the second sketch lines LS2 are formed using the laser beam LR.

As described herein, a "plan view" may refer to a plane and/or a normal view thereof (e.g., a view along a normal vector of the plane), where the plane extends in the first and second directions (e.g., X-axis and Y-axis directions) and/or extends parallel to one or more structures, surfaces, or the like as described herein (e.g., an XY plane or a normal view of such a plane, a plane extending parallel to the first substrate US_M of the mother substrate MSUB at least at the time of one or more of operations S110 to S160 and/or a normal view of such plane, any combination thereof, or the like). Accordingly, where a shape, position, and/or arrangement of one or more elements is described herein "in (a) plan view," it will be understood that the described shape, position, and/or arrangement of the one or more elements is a shape, position, and/or arrangement in a plane (an XY plane extending in the first and second directions, a plane extending parallel to the first substrate US_M of the mother substrate MSUB at least at the time of one or more of operations S110 to S160, or the like) and/or a normal view of such a plane.

Referring to both S130 and S140, and further referring to FIG. 13, the formation of a sketch line LS (which may be a first sketch line LS1 or a second sketch line LS2) may include irradiating the second surface BS_M of the mother substrate MSUB using the laser beam LR, where the laser beam LR may be a Bessel laser beam that is controlled so that the focus of the laser beam LR irradiated onto the second surface BS_M is at or proximate to the opposite first surface US_M of the mother substrate MSUB, which may thereby cause removal (e.g., via ablation) of a portion of the mother substrate material at a particular location at the first surface US_M of the mother substrate MSUB. The laser beam LR (e.g., Bessel beam) may be controlled to move the focus of the laser beam LR along a path in the third direction (e.g., negative Z-axis direction) from the first surface US_M towards the second surface BS_M to a particular depth T_CH from the first surface US_M in the third direction into the interior of the mother substrate MSUB, thereby causing removal (e.g., via ablation) of mother substrate material along the path to form a cylindrical channel (also referred to herein as a bore, a hole, and/or a trench) as shown in FIG. 13. The cylindrical channel may be referred to herein as an irradiation area CH having the depth T_CH. As shown in FIG, 13, the laser beam LR may then be controlled to form a plurality of such irradiation areas CH, and a pattern or arrangement of irradiation areas CH formed in the mother substrate MSUB may at least partially define a sketch line LS (which may be a first sketch line LS1 or a second sketch line LS2) that extends from the first surface US_M toward the second surface BS_M as defined by the depth T_CH and may extend in one or more directions parallel to the first surface US_M as defined by the pattern or arrangement of the irradiation areas CH. As shown in FIG. 13, a sketch line LS that is defined by a plurality of irradiation areas CH may be understood to extend sequentially (e.g., in series) through each of the plurality of irradiation areas CH in a plan view (e.g., in a plane extending parallel to the first surface US_M extending in the first and/or second directions, and/or a normal view thereof) and extending to a depth in the third direction defined by the depth T_CH of the plurality of irradiation areas CH, as shown in at least FIG. 13. Accordingly, sketch lines LS as described herein (e.g., first sketch lines LS1 and/or second sketch lines LS2) may be defined by the depth T_CH and pattern or arrangement of a plurality of irradiation areas CH.

As shown in at least FIG. 15, a first sketch line LS1 may be defined by a plurality of irradiation areas CH formed to define an area, in a plan view (e.g., in a plane extending parallel to the first surface US_M at S130, for example the XY plane as shown in FIG. 15, and/or a normal view thereof) that conformally surrounds and/or encompasses a display cell DPC on the mother substrate MSUB (e.g., surrounds the entirety of the display cell DPC in the plan view), such that a plurality of first sketch lines LS1 may be formed at S130 by separate, respective patterns of irradiation areas CH defining separate, respective areas in the plan view that surround separate, respective display cells DPC on the mother substrate MSUB. As shown, a first sketch line LS1 may comprise one or more line segments (which may be linear or nonlinear line segments), defined by a plurality of irradiation areas CH, that conformally surround the entirety of the display cell DPC in the plan view, such that the first sketch line LS1 as defined by the irradiation areas CH conformally follows the contour defined by the edges DPCe of the display cell DPC. For example, as shown in at least FIG. 15, a first sketch line LS1 conformally surrounding the edges DPCe of a display cell DPC may comprise one or more line segments, defined by separate sets of irradiation areas CH collectively defining the first sketch line LS1, that each extend parallel to a separate, respective edge DPCe of the display cell DPC, and where the separate line segments are connected to define the first sketch line LS1 so that the first sketch line LS1 conformally surrounds the entire display cell DPC and is understood to be located and/or to extend "along" the edges DPCe of the display cell DPC. Accordingly, where a plurality of first sketch lines LS1 are formed at S130, the plurality of first sketch lines LS1 may be understood to be located along edges DPCe of the plurality of display cells DPCe (e.g., where each separate first sketch line LS1 extends along edges DPCe of a separate display cell DPC to surround the separate display cell DPC in the plan view). As shown, each separate first sketch line LS1 may define a separate area, in a plan view, that conformally surrounds a separate display cell DPC, such that the separate first sketch line LS1 defines a shape, in the plan view, that is the same or substantially the same as the shape of the display cell DPC in the plan view (e.g., the relative dimensions, such as length:width ratio, of the area defined by the first sketch line LS1 being within a 10% margin of the relative dimensions, such as length:width ratio, of the display cell DPC surrounded by the first sketch line LS1 in the plan view), and where the area defined by a separate first sketch line LS1 in the plan view surrounding a display cell DPC in the plan view may be about 0.01% to about 10% greater than the area of the display cell DPC in the plan view.

As shown in at least FIG. 15, a second sketch line LS2 may be defined by a plurality of irradiation areas CH formed to define an area, in a plan view (e.g., in a plane extending parallel to the first surface US_M at S130, for example the XY plane as shown in FIG. 15, and/or a normal view thereof) that is surrounded by an inorganic encapsulation area IEA and a wiring area WLA of the display cell DPC in the plan view. Accordingly, where a plurality of second sketch lines LS2 are formed at S140, the plurality of second sketch lines LS2 may be understood to be surrounded by an inorganic encapsulation area IEA and a wiring area WLA of a separate display cell DPC in a plan view.

Fifth, as illustrated in FIGS. 23 and 29, a second protective film PRF2 is attached onto the first protective films PRF1 (operation S150 in FIG. 12).

The second protective film PRF2 may be attached onto the first protective films PRF1 and the mother substrate MSUB exposed without being covered by the first protective films PRF1. The second protective film PRF2 may cover the laser irradiation areas CH of the first sketch lines LS1 and the second sketch lines LS2. The second protective film PRF2 may be an acid-resistant film for protecting the display cells DPC from an etchant ECH in an etching process of the mother substrate MSUB which will be performed in a next operation.

Sixth, as illustrated in FIGS. 17, 23 and 29, the mother substrate MSUB is slimmed (to form a slimmed mother substrate MSUBs) by spraying the etchant ECH onto the second surface BS_M of the mother substrate MSUB without using a mask (operation S160 in FIG. 12).

When the etchant ECH is sprayed onto the second surface BS_M of the mother substrate MSUB, the mother substrate MSUB may be reduced by an etched depth EtD, also referred to herein interchangeably as an etched thickness, from a first thickness TH1 to a second thickness TH2. Since the mother substrate MSUB is etched without using a mask, it may be isotropically etched, that is, the entire second surface BS_M of the mother substrate MSUB may be uniformly etched. It will be understood that "slimming" the mother substrate MSUB refers to uniformly or substantially uniformly reducing a thickness of the mother substrate MSUB between opposite first and second surfaces US_M and BS_M in the third direction (e.g., Z-axis direction) from a first thickness TH1 to a second thickness TH2 that is smaller than the first thickness TH1, to form a slimmed mother substrate MSUBs having the second thickness TH2.

The above etching process may reduce a first distance D1 which is a distance (e.g., a length in the third direction (Z-axis direction)) between the second surface BS_M of the mother substrate MSUB and the laser irradiation areas CH in the third direction (e.g., Z-axis direction).

In some example embodiments, a depth T_CH of each of the laser irradiation areas CH from the first surface US_M of the mother substrate MSUB may be smaller than the second thickness TH2 which is a thickness (i.e., a thickness remaining after the etching) excluding an etched depth EtD (also referred to herein interchangeably as an etched thickness) from the first thickness TH1 which is a total thickness of the mother substrate MSUB (e.g., a thickness between opposite first and second surfaces US_M and BS_M of the mother substrate MSUB). That is, the first distance D1 may be greater than 0. For example, the first distance D1 may be about 10% to about 20% of the etched depth EtD (e.g., a difference between the first thickness TH1 and the second thickness TH2) in consideration of the processing tolerance and etching tolerance of each laser irradiation area CH.

In some example embodiments, when the first thickness TH1 of the mother substrate MSUB is about 500 µm and the second thickness TH2 is about 200 µm, the depth T_CH of each of the laser irradiation areas CH may be about 135 µm to about 175 µm from the first surface US_M of the mother substrate MSUB. Preferably, the depth T_CH of each of the laser irradiation areas CH (e.g., in the third direction or Z-axis direction) may be about 150 µm from the first surface US_M of the mother substrate MSUB.

When the laser beam LR is irradiated onto the second surface BS_M of the mother substrate MSUB, the depth (or sketch length) T_CH of each of the laser irradiation areas CH may be adjusted according to repetition rate, processing speed, and pulse energy.

According to the method S1 of manufacturing the display device according to some example embodiments, since the depth T_CH of each of the laser irradiation areas CH is smaller than the etched depth EtD, it is possible to prevent an etchant from penetrating onto the first surface US_M of the mother substrate MSUB and damaging the display cells DPC, or to reduce or minimize the likelihood of such penetration.

In some example embodiments, the slimming of the mother substrate MSUB by spraying the etchant ECH onto the second surface BS_M of the mother substrate MSUB without using the mask (operation S160) may be omitted or may be performed before the forming of the first sketch lines LS1 by irradiating the laser beam LR (operation S130) or the forming of the second sketch lines LS2 by irradiating the laser beam LR (operation S140). For example, in the method S1 of manufacturing the display device, the slimmed mother substrate MSUB (MSUBs) may be provided and used before a laser processing process is performed, or the mother substrate MSUB may be slimmed before the laser processing process (e.g., before one or both of S130 and/or S140).

Seventh, as illustrated in FIGS. 18 through 20, 24 through 26 and 30 through 32, the display cells DPC are separated from the mother substrate MSUB and the through holes TH are formed based on cutting or "dividing" the mother substrate MSUB (e.g., the slimmed mother substrate MSUBs) along the first and second sketch lines LS1 and LS2 using a stage STG including step portions STP (operation S170 in FIG. 12), for example based on positioning the stage STG in relation to the mother substrate MSUB (e.g., the slimmed mother substrate MSUBs).

The stage STG may include a stage body STB, the step portions STP, and suction holes VCH.

The step portions STP may be located on (e.g., may project upwards in the third direction or Z-axis direction from) an upper surface STBS of the stage body STB of the stage STG. For example, the step portions STP may be located between the stage body STB of the stage STG and the mother substrate MSUB. Upper surfaces STPS of the step portions STP may be located higher than a portion of the upper surface STBS of the stage body STB of the stage STG where the step portions STP are not located in a direction perpendicular to the upper surfaces STPS and/or STBS (e.g., the third direction or Z-axis direction). Accordingly, there may be a height difference in the third direction (e.g., Z-axis direction) between a portion where the step portions STP are located and a portion where the step portions STP are not located. Restated, the stage STG may define a step height difference of the upper surfaces STPS of the step portions STP above the upper surface STBS of the stage body STB in a direction perpendicular to the upper surfaces STPS and/or STBS (e.g., the third direction or Z-axis direction).

The step portions STP may include first step portions STP1, and the dividing at S170 may include positioning the stage STG in relation to the mother substrate MSUB (the mother substrate MSUB at S170 being referred to herein interchangeably as the slimmed mother substrate MSUBs) such that each first step portion STP1 of the plurality of first step portions STP1 is adjacent to a separate first sketch line LS1 of the plurality of first sketch lines LS1 in a plan view (e.g., adjacent in the X-axis and/or Y-axis directions) during a process of separating the display cells DPC from the mother substrate MSUB. The step portions STP may include second step portions STP2, and the dividing at S170 may include positioning the stage STG in relation to the mother substrate MSUB such that each second step portion STP2 of the plurality of second step portions STP2 is adjacent to a separate second sketch line LS2 of the plurality of second sketch lines LS2 in a plan view (e.g., adjacent in the X-axis and/or Y-axis directions) during the formation of the through holes TH. Step portions STP that are adjacent to a sketch line LS in a plan view as described herein may be immediately adjacent (e.g., immediately adjacent in the X-axis and/or Y-axis directions) or may be spaced apart in the plan view (e.g., spaced apart in the X-axis and/or Y-axis directions), for example spaced apart in the X-axis and/or Y-axis directions by a distance equal to or less then the depth T_CH of the irradiation area(s) CH defining the sketch line LS (e.g., between 0% and 80% of T_CH, between 0% and 50% of T_CH, between 0% and 20% of T_CH, between 0% and 10% of T_CH, or the like).

In some example embodiments, as illustrated in FIG. 19, operation S170 may include positioning the stage STG in relation to the mother substrate MSUB so that each of the first step portions STP1 may be located inside a first sketch line LS1 in a plan view. Restated, operation S170 may include positioning the stage STG in relation to the mother substrate MSUB so that, in a plan view, the plurality of first step portions STP1 may be surrounded by separate, respective first sketch lines LS1 of the plurality of first sketch lines LS1. Further restated, operation S170 may include positioning the stage STG in relation to the mother substrate MSUB so that, in a plan view, the plurality of first step portions STP1 may each be entirely located in and/or overlapped with an area defined by (e.g., having a periphery defined by) a separate one first sketch line LS1 of the plurality of first sketch lines LS1. For example, each of the first step portions STP1 may be located on a side of the first sketch line LS1 where a display cell DPC is located in the plan view. The first sketch lines LS1 may surround separate, respective first step portions STP1 in the plan view.

In some example embodiments, as illustrated in FIG. 19, operation S170 may include positioning the stage STG in relation to the mother substrate MSUB so that each of the second step portions STP2 may be located outside (e.g., may surround) a second sketch line LS2 in a plan view. Restated, operation S170 may include positioning the stage STG in relation to the mother substrate MSUB so that, in a plan view, the plurality of second sketch lines LS2 may be surrounded by separate, respective second step portions STP2 of the plurality of second step portions STP2. Further restated, operation S170 may include positioning the stage STG in relation to the mother substrate MSUB so that, in a plan view, the plurality of second sketch lines LS2 may each be entirely located in and/or overlapped with an area defined by (e.g., having a periphery defined by) a separate one second step portion STP2 of the plurality of second step portions STP2. For example, each of the second step portions STP2 may be located on an opposite side of the second sketch line LS2 from a portion where a through hole TH is to be formed in the plan view. The second step portions STP2 may surround the second sketch lines LS2 in the plan view.

One or more suction holes VCH may extend through a thickness of the stage body STB. The suction holes VCH may include one or more first suction holes VCH1 surrounded by a first step portion STP1 of the plurality of first step portions STP1 in a plan view, such that the one or more first suction holes VCH1 may be understood to be located "inside" an area having a periphery defined by one first step portion STP1 in the plan view. The suction holes VCH may include one or more second suction holes VCH2 external to any areas having a periphery defined by any of the first step portions STP1 in a plan view, such that the one or more second suction holes VCH2 may be understood to be between at least two separate first step portions STP1 of the plurality of first step portions STP1 in the plan view. For example, as illustrated in FIGS. 18, 19, 24, and 30, one or more suction holes VCH (also referred to herein as suction channels), may extend through a thickness of the stage body STB, between opposite lower and upper surfaces STBB and STBS of the stage body STB, such that a top opening VCHO of the one or more suction holes VCH may be defined in the upper surface STBS of the stage body STB. As shown in FIGS. 18, 19, and 24, the top openings VCHO of one or more first suction holes VCH1, and thus the one or more first suction holes VCH1 themselves, may be located inside (e.g., may be open to) a space STPV1 that is at least partially defined and/or enclosed in at least the plan view (e.g., defined and/or enclosed in the XY plane) by one or more inner sidewall surfaces STP1i of a first step portion STP1 and thus may be surrounded by the first step portion STP1 in the plan view. As shown in FIGS. 18, 19, and 24, the top openings VCHO of one or more second suction holes VCH2, and thus the one or more second suction holes VCH2 themselves, may be located in (e.g., may be open to) a separate space STPVE outside the spaces STPV1 defined by the plurality of first step portions STP1, where the separate space STPVE may be defined in at least the plan view (e.g., the XY plane) by one or more outer sidewall surfaces STP1o of the plurality of first step portions STP1, and thus the one or more second suction holes STP2 may be between at least two separate first step portions STP1 in the plan view. Although not illustrated in FIG. 18, one or more third suction holes VCH3 may also be located inside (e.g., may be open to) a space STPV2 defined in at least the plan view (e.g., defined and/or enclosed in the XY plane) by one or more inner sidewall surfaces STP2i of a second step portion STP2 (e.g., as shown in FIG. 30) and thus one or more third suction holes VCH3 may be surrounded by a second step portion STP2 of the plurality of second step portions STP2 in a plan view.

As illustrated in FIG. 24, one or more suction holes VCH (e.g., one or more first suction holes VCH1) may be located in (e.g., may be open to) an area overlapping and/or overlapped by a display cell DPC in the third direction (Z-axis direction) and one or more suction holes VCH (e.g., one or more second suction holes VCH2) may be located in (e.g., may be open to) an area not overlapping and/or no overlapped by (e.g., exposed from) the display cell DPC in the third direction (Z-axis direction) with respect to each first step portion STP1. Similarly, as illustrated in FIG. 30, one or more suction holes VCH (e.g., one or more third suction holes VCH3) may be located in each of an area overlapping and/or overlapped by a display cell DPC in the third direction (Z-axis direction) and an area where a through hole TH is to be located with respect to each second step portion STP2 (e.g., overlapping and/or overlapped by such area where the through hole TH is to be formed in the third direction or Z-axis direction).

The suction holes VCH (e.g., the first to third suction holes VCH1 to VCH3) may be connected (e.g., at a bottom opening defined in the lower surface STBB of the stage body STB) to a vacuum suction device (e.g., a vacuum pump). The vacuum suction device may operate to at least partially evacuate the spaces STPV1, STPV2, and STPVE through the suction holes VCH so as to apply suction force to the mother substrate MSUB through the suction holes VCH. The mother substrate MSUB may be fixed against the stage STG (e.g., drawn into contact with the upper surfaces STP1S and STP2S of the first and second step portions STP1 and STP2 and further drawn into contact with upper surfaces STBS of the stage body STB) by the suction force of the vacuum suction device and the suction holes VCH. In this state, the process of separating the display cells DPC from the mother substrate MSUB and the process of forming the through holes TH may be performed.

A step portion STP may form a step (e.g., a step height difference in the Z-axis direction) between each display cell DPC and a dummy portion DUM during the process of separating the display cell DPC from the mother substrate MSUB, and another step portion STP may form a step (e.g., a step height difference in the Z-axis direction) between each through hole portion TH and a display cell portion DPC other than the through hole TH during the formation of the through hole TH. That is, each display cell DPC may be formed to be different in height (e.g., in the Z-axis direction) from the dummy portion DUM with respect to a first sketch line LS1 based on the mother substrate MSUB being fixed against the stage STG as described above due to the suction force, and each through hole portion TH may be formed to be different in height (e.g., in the Z-axis direction) from a portion of the display cell DPC other than each through hole TH with respect to a second sketch line LS2 based on the mother substrate MSUB being fixed against the stage STG as described above due to the suction force.

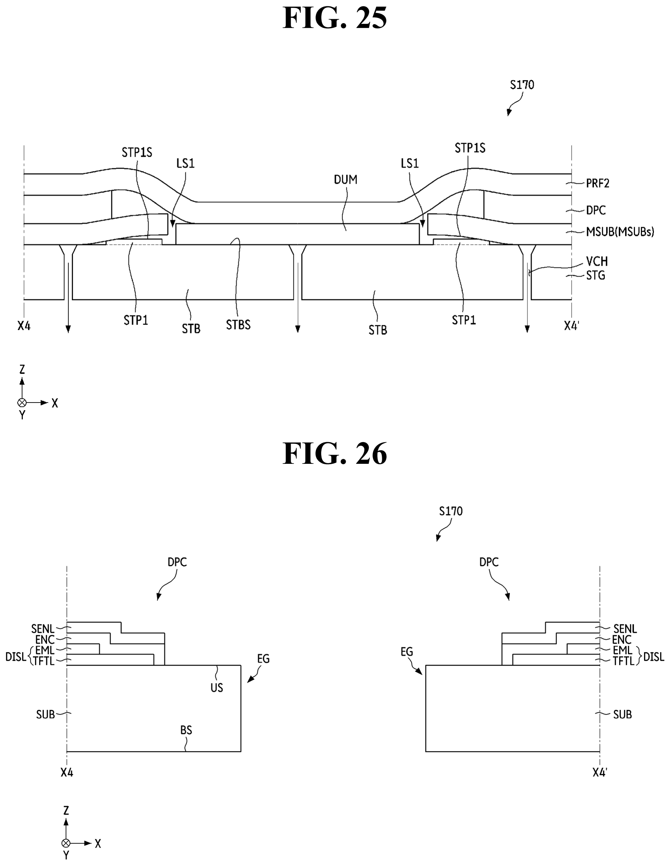

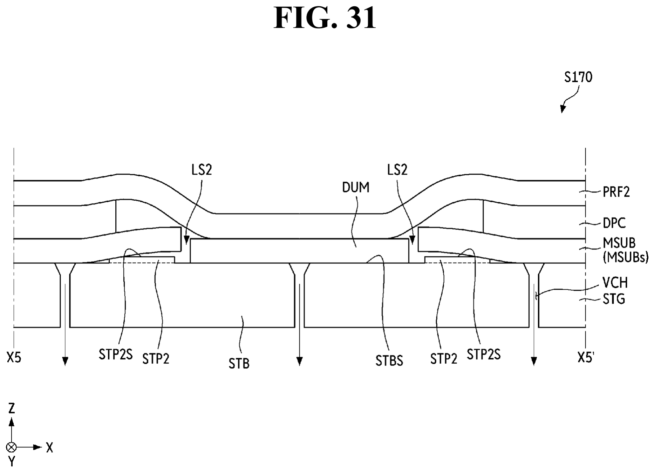

In this state, if the vacuum suction device and the suction holes VCH apply a suction force to the mother substrate MSUB, the mother substrate MSUB may be divided along the first and second sketch lines LS1 and LS2 by the principle of the lever as illustrated in FIGS. 25 and 31.

For example, referring to FIG. 25, based on the mother substrate MSUB being drawn against surfaces STBS and STP1S of the stage STG as shown based on the suction force being applied to the mother substrate MSUB, a first step portion STP1 of the stage STG may cause the mother substrate MSUB to break in the third direction (Z-axis direction) along a first sketch line LS1 surrounding a display cell DPC in plan view to separate the display cell DPC from the mother substrate MSUB based on a height difference in the Z-axis direction between a portion of the mother substrate MSUB contacting the upper surface STP1S of the first step portion STP1 at one side of the first sketch line LS1 in the plan view (e.g., in the X-axis and/or Y-axis directions) and a proximate portion of the mother substrate MSUB contacting the upper surface STBS of the stage body STB at an opposite side of the first sketch line LS1 in the plan view (e.g., in the X-axis and/or Y-axis directions) and being offset from the upper surface STP1S in the Z-axis direction. As a result, the break in the mother substrate MSUB (e.g., the dividing the mother substrate MSUB) to separate the display cell DPC from the mother substrate MSUB may be induced based on lever action between the separate portions of the mother substrate MSUB at opposite sides of the first sketch line LS1 surrounding the display cell DPC in the plan view (e.g., in the X-axis and/or Y-axis directions) and at different heights in the Z-axis direction due to contacting different surfaces of the upper surface STP1S or the upper surface STBS, for example due to stress concentration at the reduced thickness portions of the slimmed mother substrate MSUBs (e.g., having first distance D1 thickness) that are overlapped in the third direction (Z-axis direction) with the irradiation areas CH defining the first and second sketch lines LS1 and LS2.

In another example, referring to FIG. 31, based on the mother substrate MSUB being drawn against surfaces STBS and STP2S of the stage STG as shown based on the suction force being applied to the mother substrate MSUB, a second step portion STP2 of the stage STG may cause the mother substrate MSUB to break in the third direction (Z-axis direction) along a second sketch line LS2 in a display cell DPC in plan view to form a through hole TH in a display cell DPC based on a height difference in the Z-axis direction between a portion of the mother substrate MSUB contacting the upper surface STP2S of the second step portion STP2 at one side of the second sketch line LS2 in the plan view (e.g., in the X-axis and/or Y-axis directions) and a proximate portion of the mother substrate MSUB contacting the upper surface STBS of the stage body STB at an opposite side of the second sketch line LS2 in the plan view (e.g., in the X-axis and/or Y-axis directions) and being offset from the upper surface STP2S in the Z-axis direction. As a result, the break in the mother substrate MSUB (e.g., the dividing the mother substrate MSUB) to form the through hole TH may be induced based on lever action between the separate portions of the mother substrate MSUB at opposite sides of the second sketch line LS2 in the plan view (e.g., in the X-axis and/or Y-axis directions) and at different heights in the Z-axis direction due to contacting different surfaces of the upper surface STP2S or the upper surface STBS, for example due to stress concentration at the reduced thickness portions of the slimmed mother substrate MSUBs (e.g., having first distance D1 thickness) that are overlapped in the third direction (Z-axis direction) with the irradiation areas CH defining the first and second sketch lines LS1 and LS2.

Accordingly, as illustrated in FIGS. 20, 26 and 32, the display cells DPC may be separated from the mother substrate MSUB along the first sketch lines LS1, and the through holes TH may be formed along the second sketch lines LS2. Then, after the separation process of the display cells DPC is completed, the first and second protective films PRF1 and PRF2 may be detached.

According to the method S1 of manufacturing the display device according to some example embodiments, since the depth T_CH of each of the laser irradiation areas CH is smaller than the etched depth EtD, the dummy portion DUM between display cells DPC which are not completely separated from the mother substrate MSUB and the dummy portion DUM at the position of each through hole TH can be completely separated from the mother substrate MSUB using the step portions STP and the suction holes VCH.

In view of at least the above, forming display devices 10 may include at least forming the first sketch lines LS1 and/or second sketch lines LS2 (S130/S140), slimming the mother substrate MSUB to form a slimmed mother substrate MSUBs based on spraying an etchant onto the second surface BS_M (S160), and separating the plurality of display cells DPC from the slimmed mother substrate MSUB and/or forming a through hole TH in a display area DA in each display cell DPC based on dividing the mother substrate using a stage STG including first step portions STP1 and/or second step portions STP2, further based on positioning the stage STG in relation to the slimmed mother substrate MSUBs such that each first step portion STP1 of the plurality of first step portions STP1 is adjacent to a separate first sketch line LS1 of the plurality of first sketch lines LS2 and/or each second step portion STP2 of the plurality of second step portions STP2 is adjacent to a separate second sketch line LS2 of the plurality of second sketch lines LS2, where the thickness D1 of remaining mother substrate material under the sketch lines LS1/LS2 is reduced due to the slimming and promotes breaking of the mother substrate MSUB (e.g., slimmed mother substrate MSUBs) at the sketch lines with improved precision and/or accuracy. As a result, the location of the separation of the display cells DPC from the mother substrate MSUB may be more precisely and reliably achieved at the locations of the first and/or second sketch lines LS1/LS2. Accordingly, the width of the non-display area NDA and/or hole non-display area HNDA of the separated display cells DPC and the display panels 100 and display devices 10 including same, particularly the width of the second portion of the second non-display area NDA2, may be more precisely and reliably achieved and therefore may be caused to be reduced or minimized with improved precision and/or reliability. Therefore, the display devices 10 that include the separated display cells DPC may exhibit increased immersion in the display area DA and enhanced aesthetic appearance may be manufactured with improved reliability.

In some example embodiments, in the method S1 of manufacturing the display device according to some example embodiments, one or more of the separated display cells DPC may be coupled with one or more additional components to manufacture a display device 10, such that a display device 10 include one or more of the separated display cells DPC may be manufactured (S180). For example, a display cell DPC separated from the mother substrate MSUB at S170 may at least partially define a display panel 100, and the manufacturing at S180 may include coupling the display panel 100 to driving ICs 200, circuit boards 300, cover window CW, polarizing film PF, under-panel cover PB, optical device OPD, and the like to manufacture a display device 10 such as shown in at least FIGS. 1 to 11.

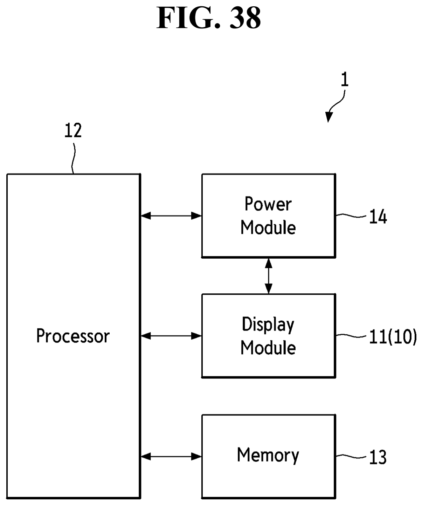

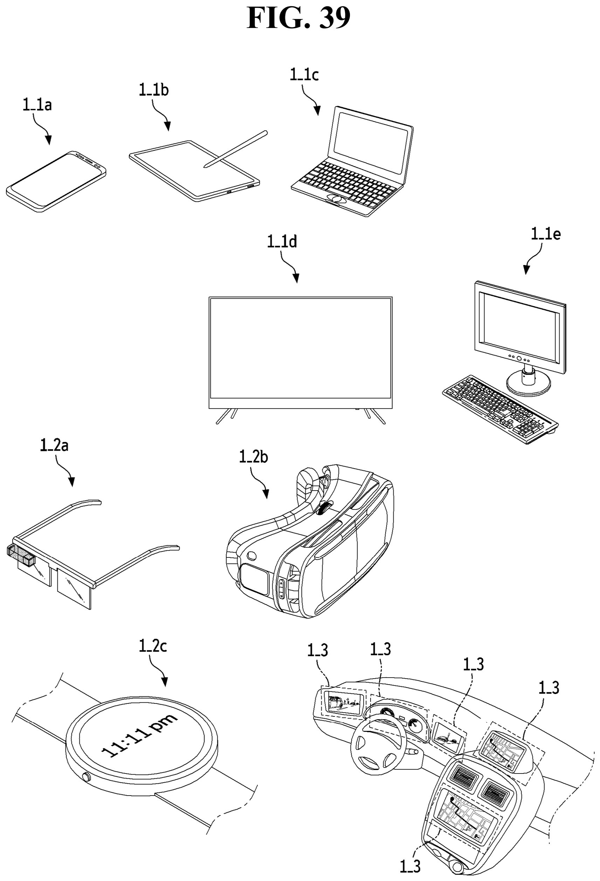

In some example embodiments, in the method S1 of manufacturing the display device according to some example embodiments, one or more of the display devices 10 may be coupled with one or more additional components to manufacture an electronic device 1, such that an electronic device 1 including one or more of the display devices 10 may be manufactured (S190). The electronic device 1 may include any of the electronic devices 1 as shown in FIGS. 38 and 39, although example embodiments are not limited thereto. For example, the manufacturing at S190 may include coupling a display device 10, at least partially defining a display module 11, with a processor 12, power module 14, and/or memory 13 to manufacture an electronic device 1 as shown in FG. 38, although example embodiments of such manufacturing at S190 are not limited thereto.

Hereinafter, examples of the method of manufacturing the display device according to some example embodiments will be described. In the following example embodiments, the same elements as those of the above-described example embodiments are identified by the same reference characters, and any redundant description thereof will be omitted or given briefly, and differences will mainly be described.

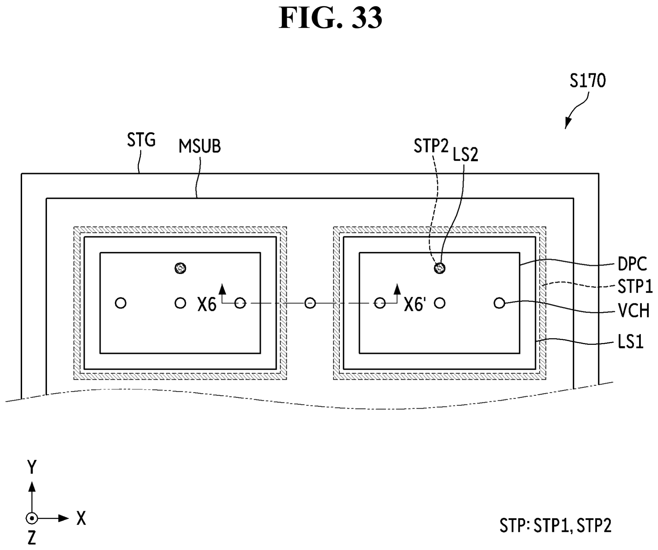

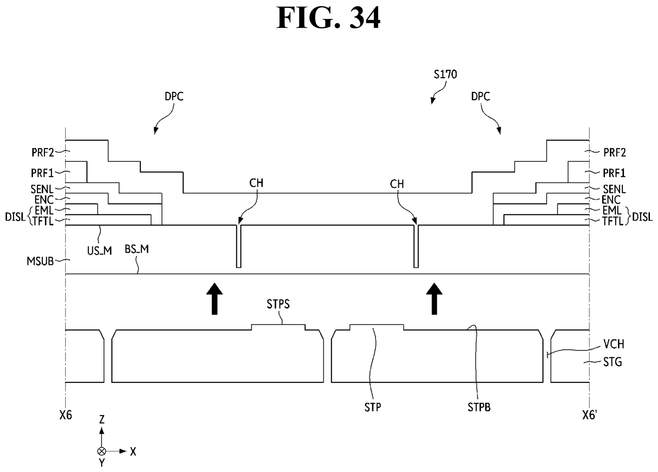

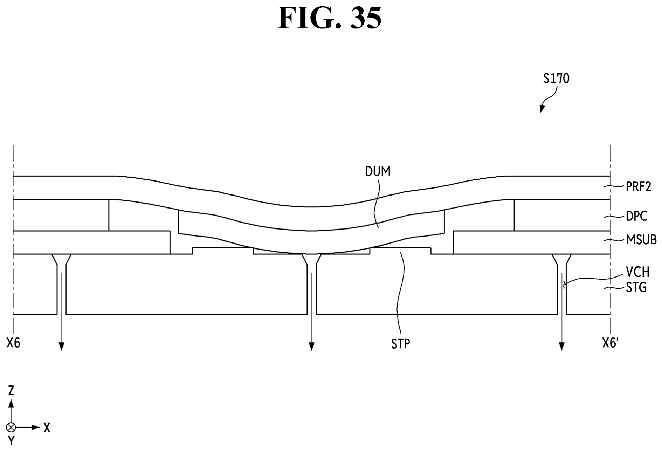

FIG. 33 is a plan view illustrating operation S170 in a method of manufacturing a display device according to some example embodiments. FIGS. 34 and 35 are cross-sectional views illustrating operation S170 in the method of manufacturing the display device shown in FIG. 33 according to some example embodiments.

Referring to FIGS. 33 through 35, the method S1 of manufacturing the display device according to some example embodiments is different from the method S1 of manufacturing the display device according to some example embodiments described above with reference to FIG. 19, etc. in the position of each step portion STP.

More specifically, as illustrated in FIG. 33, each of first step portions STP1 may be located outside a first sketch line LS1 in a plan view (e.g., outside an area that is defined by the first sketch line LS1 in the plan view), based on the stage STG being positioned in relation to the mother substrate MSUB, for example such that each first step portion STP1 may at least partially surround a respective display cell DPC and a respective set of one or more first sketch lines LS1 surrounding the display cell DPC in the plan view. Thus, the plurality of first sketch lines LS1 may be surrounded by separate, respective first step portions STP1 of the plurality of first step portions STP1 in a plan view. For example, each of the first step portions STP1 may be located on an opposite side of a first sketch line LS1 from a display cell DPC in a plan view. The first step portions STP1 may surround separate, respective first sketch lines LS1 that are extending along edges of a particular display cell DPC in a plan view.

As illustrated in FIG. 33, each of second step portions STP2 may be located inside a second sketch line LS2 in a plan view (e.g., inside an area that is defined by the second sketch line LS2 in the plan view) based on the stage STG being positioned in relation to the mother substrate MSUB. Thus, the plurality of second step portions STP2 may be surrounded by separate, respective second sketch lines LS2 of the plurality of second sketch lines LS2. For example, each of the second step portions STP2 may be located on a side of a second sketch line LS2 where a through hole TH is to be formed in a plan view. The second sketch lines LS2 may surround separate, respective second step portions STP2 in a plan view.

In some example embodiments, including the example embodiments shown in FIG. 19, the first sketch lines LS1 surround separate, respective first step portions STP1 in a plan view, and the second sketch lines LS2 are surrounded by separate, respective second step portions STP2 in the plan view. In some example embodiments of FIG. 33, the first sketch lines LS1 are surrounded by separate, respective first step portions STP1 in a plan view, and the second sketch lines LS2 surround separate, respective second step portions STP2 in the plan view. However, example embodiments are not limited thereto.

For example, in some example embodiments, the first sketch lines LS1 may surround separate, respective first step portions STP1 in a plan view, and the second sketch lines LS2 may surround separate, respective second step portions STP2 in the plan view. In addition, in some example embodiments, the first sketch lines LS1 may be surrounded by separate, respective first step portions STP1 in a plan view, and the second sketch lines LS2 may be surrounded by separate, respective second step portions STP2 in the plan view.

A first step portion STP1 may be located on one side of each first sketch line LS1 in a plan view but may not be located on the other side (e.g., opposite side) of each first sketch line LS1 in the plan view. For example, the dividing in operation S170 may include positioning the stage STG in relation to the slimmed mother substrate MSUBs such that, in a plan view, the plurality of first step portions STP1 are surrounded by separate, respective first sketch lines LS1 of the plurality of first sketch lines LS1, or the plurality of first sketch lines LS1 are surrounded by separate, respective first step portions STP1 of the plurality of first step portions STP1. In another example, the dividing in operation S170 may include positioning the stage STG in relation to the slimmed mother substrate MSUBs such that, in a plan view, each first step portion STP1 of the plurality of first step portions STP1 is located at one side or an opposite side of a separate first sketch line LS1 of the plurality of first sketch lines LS1. In addition, a second step portion STP2 may be located on one side of each second sketch line LS2 in a plan view but may not be located on the other side of each second sketch line LS2 in the plan view. For example, the dividing in operation S170 may include positioning the stage STG in relation to the slimmed mother substrate MSUBs such that, in a plan view, the plurality of second step portions STP2 are surrounded by separate, respective second sketch lines LS2 of the plurality of second sketch lines LS2, or the plurality of second sketch lines LS2 are surrounded by separate, respective second step portions STP2 of the plurality of second step portions STP2. In another example, the dividing in operation S170 may include positioning the stage STG in relation to the slimmed mother substrate MSUBs such that, in a plan view, each second step portion STP2 of the plurality of second step portions STP2 is located at one side or an opposite side of a separate first sketch line LS2 of the plurality of second sketch lines LS2. In some example embodiments, as shown in FIGS. 34 and 35, there may be a height difference (e.g., in the Z-axis direction perpendicular to the plane extending parallel to the first surface US_M of the mother substrate MSUB) between the two sides. Then, as shown in FIGS. 34 and 35, a mother substrate MSUB may be divided according to the principle of the lever by the suction applied to the mother substrate MSUB through the suction holes VCH. Accordingly, the display cells DPC may be separated from the mother substrate MSUB, and the through holes TH may be formed.

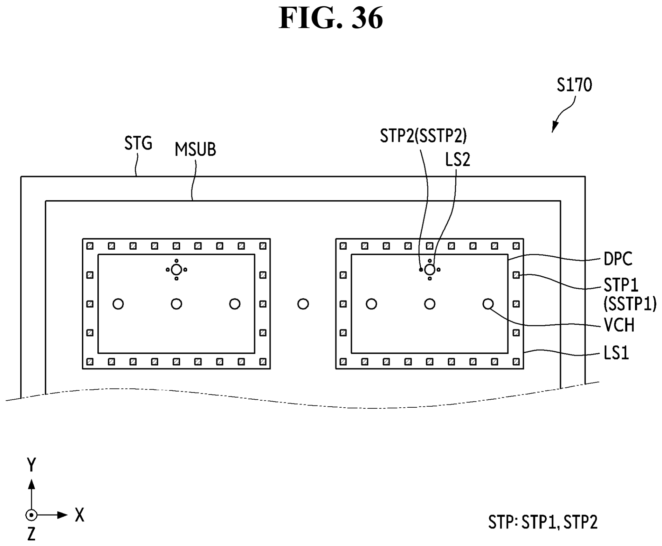

FIG. 36 is a plan view illustrating operation S170 in a method of manufacturing a display device according to some example embodiments.

Referring to FIG. 36, the method S1 of manufacturing the display device according to some example embodiments is different from the methods S1 of manufacturing the display device according to some example embodiments, including the example embodiments described above with reference to FIGS. 19 and 33, etc. in the shape of each step portion STP.

More specifically, as in the methods S1 of manufacturing the display device according to some example embodiments, including the example embodiments described above with reference to FIGS. 19 and 33, etc., each step portion STP may be a fence-type or quadrangular ring-type step portion that can divide areas inside and outside the step portion STP in a plan view, for example based on surrounding (e.g., defining a periphery of) separate, respective areas in the plan view. In some example embodiments, as illustrated in FIG. 36, the step portions STP may be island-type step portions spaced apart from each other in a plan view. For example, as shown in FIG. 36, a first step portion STP1 may be defined by, and thus may include, a plurality of island-type step portions SSTP1. In another example, as shown in FIG. 36, a second step portion STP2 may be defined by, and thus may include, a plurality of island-type step portions SSTP2.

For example, as illustrated in FIG. 36, island-type first step portions SSTP1 defining a first step portion STP1 may be located inside (e.g., surrounded by) a first sketch line LS1 (e.g., inside an area defined by a first sketch line LS1 in a plan view) and may not be located outside any first sketch line LS1 (e.g., outside any such area in the plan view). In addition, island-type second step portions SSTP2 defining a second step portion STP2 may be located outside each second sketch line LS2 (e.g., outside an area defined by each second sketch line LS2 in a plan view) and may not be located inside each second sketch line LS2 (e.g., not located inside said area).

However, example embodiments are not limited thereto. The island-type first step portions SSTP1 defining s first step portion STP1 may not be located inside each first sketch line LS1 (e.g., inside an area defined by a first sketch line LS1 in a plan view) and may be located outside each first sketch line LS1 (e.g., outside said area in the plan view). In addition, the island-type second step portions SSTP2 defining a second step portion STP2 may not be located outside each second sketch line LS2 (e.g., not located outside an area defined by a second sketch line LS2 in a plan view) and may be located inside each second sketch line LS2 (e.g., located inside said area).

The shape of each step portion STP can be variously changed. For example, as illustrated in FIG. 36, the first step portions STP1 may have a quadrangular shape, and the second step portions STP2 may have a circular shape. However, example embodiments are not limited thereto, and the first step portions STP1 and the second step portions STP2 can be changed into various shapes such as polygonal, circular, and oval shapes.

In FIG. 36, island-type step portions STP, instead of a fence-type step portion STP, are located in each portion where the fence-type step portion STP is located in FIGS. 19 and 33, but example embodiments of the present inventive concepts are not limited thereto.

For example, a first step portion STP1 may be located only near four vertices of a quadrangle defined by each first sketch line LS1, and a second step portion STP2 may be located only at a center of a circle defined by each second sketch line LS2 in a plan view. That is, the number and arrangement of the island-type step portions STP can be variously changed.

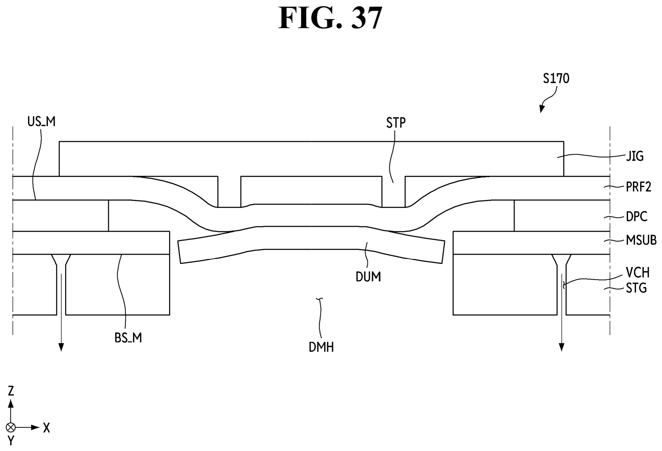

FIG. 37 is a cross-sectional view illustrating operation S170 in a method of manufacturing a display device according to some example embodiments.

Referring to FIG. 37, the method S1 of manufacturing the display device according to some example embodiments is different from the methods S1 of manufacturing the display device according to some example embodiments, including the example embodiments shown in FIGS. 12 to 36 in that it further includes a pressing jig JIG.

More specifically, according to the method S1 of manufacturing the display device according to some example embodiments, a mother substrate MSUB is cut along a plurality of first and second sketch lines LS1 and LS2 using the pressing jig JIG to separate display cells DPC from the mother substrate MSUB and form through holes TH.

The pressing jig JIG may be positioned in relation to the mother substrate MSUB, for example the slimmed mother substrate MSUBs, such that the pressing jig JIG may be positioned on (e.g., above) a first surface US_M of the mother substrate MSUB. The pressing jig JIG may include step portions STP. The step portions STP of the pressing jig JIG may have the same or substantially the same configuration as the step portions STP according to the above-described example embodiments except that they are included in the pressing jig JIG instead of a stage STG.

As illustrated in FIG. 37, the mother substrate MSUB may be fixed by suction holes VCH of the stage STG. Then, the pressing jig JIG may apply pressure to the mother substrate MSUB in a direction from the first surface US_M of the mother substrate MSUB toward a second surface BS_M (e.g., in the negative Z-axis direction). A step portion STP located on one side or a short side of a sketch line LS in the X-axis direction and/or the Y-axis direction may cause a pressure difference between a display cell DPC and a dummy portion DUM. Accordingly, the display cell DPC may be separated from the mother substrate MSUB. The same technical spirit may also apply when a through hole TH is formed.

The stage STG may include (e.g., may have one or more inner surfaces defining) a dummy hole DMH instead of the step portions STP. A width or area of the dummy hole DMH may be greater than a width or area between sketch lines LS. The dummy portion DUM of the mother substrate MSUB may be taken out through the dummy hole DMH.

In some example embodiments, the stage STG may be omitted. In this case, the pressing jig JIG may fix the mother substrate MSUB by further including a lower jig positioned on the second surface BS_M of the mother substrate MSUB.

The display device 10 according to some example embodiments, including the above-described example embodiments, may be applied to (e.g., included in) various electronic devices 1. An electronic device 1 according to some example embodiments may include the above-described display device 10 and may further include modules or devices having other additional functions, in addition to the display device 10.

FIG. 38 is a block diagram of an electronic device 1 according to some example embodiments.

The electronic device 1 according to some example embodiments may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and a controller.

The memory 13 may store data information necessary for the operation of the processor 12 or the display module 11. When the processor 12 executes an application stored in the memory 13, the processor 12 may provide (e.g., transmit) an operation signal such as an image data signal and/or an input control signal to the display module 11, and the display module 11 may process the received operation signal and output (e.g., transmit, display, etc.) image information through a display screen.

The power module 14 may include a power supply module such as a power adapter or a battery device and a power conversion module which generates the power necessary for the operation of the electronic device 1 by converting power supplied by the power supply module.

At least one of the components of the electronic device 1 described above may be included in the display device 10 according to some example embodiments, including the above-described example embodiments. In addition, some of individual modules functionally included in one module may be included in the display device 10, and other modules may be provided separately from the display device 10. For example, the display device 10 may include the display module 11, and the processor 12, the memory 13 and the power module 14 may be provided not in the display device 10 but in the form of other devices within the electronic device 1.

FIG. 39 is a schematic diagram of electronic devices according to some example embodiments.

Referring to FIG. 39, various electronic devices 1 to which the display device 10 according to some example embodiments is applied may include not only image display electronic devices 1 such as a smartphone 1_1a, a tablet PC 1_1b, a laptop 1_1c, a television 1_1d and a desk monitor 1_1e, but also wearable electronic devices 1 including display modules, such as smart glasses 1_2a, a head mounted display 1_2b and a smart watch 1_2c, and vehicle electronic devices 1_3 including display modules, such as a center information display (CID) and a room mirror display placed on an instrument panel, center fascia and dashboard of a vehicle.

## Claims

1. A method of manufacturing a display device (10), the method comprising:
forming a plurality of display cells (DPC) on a first surface (US_M) of a mother substrate (MSUB), the mother substrate including the first surface and a second surface (BS_M), the second surface facing the first surface;
forming a plurality of first sketch lines (LS1) extending from the first surface toward the second surface and located along edges (DPCe) of the plurality of display cells, based on irradiating a laser beam onto at least one of the first surface or the second surface;
slimming the mother substrate to form a slimmed mother (MSUBs) substrate based on spraying an etchant (ECH) onto the second surface; and
separating the plurality of display cells from the slimmed mother substrate based on dividing the mother substrate using a stage (STG), the stage including a plurality of first step portions (STP1), the dividing including positioning the stage in relation to the slimmed mother substrate such that each first step portion of the plurality of first step portions is adjacent to a separate first sketch line of the plurality of first sketch lines.

2. The method of claim 1, wherein a thickness(TH2) of the slimmed mother substrate (MSUBs) is greater than a depth (T_CH) of each first sketch line (LS1) of the plurality of first sketch lines.

3. The method of claim 2, wherein,
the slimming the mother substrate includes reducing the thickness of the mother substrate (MSUB) by an etched thickness, and
a distance (D1) between the second surface (BS_M) and the plurality of first sketch lines (LS 1) in the slimmed mother substrate (MSUBs) is 10% to 20% of the etched thickness.

4. The method of any one of the preceding claims, wherein the dividing includes positioning the stage (STG) in relation to the slimmed mother substrate (MSUBs) such that, in a plan view, the each first step portion (STP1) is located at one side or an opposite side of the separate first sketch line (LS1).

5. The method of claim 4, wherein the dividing includes positioning the stage (STG) in relation to the slimmed mother substrate (MSUBs) such that, in the plan view, the plurality of first step portions (STP1) are surrounded by separate, respective first sketch lines (LS1) of the plurality of first sketch lines.

6. The method of claim 4, wherein the dividing includes positioning the stage (STG) in relation to the slimmed mother substrate (MSUBs) such that, in the plan view, the plurality of first sketch lines (LS1) are surrounded by separate, respective first step portions (STP1) of the plurality of first step portions.

7. The method of any one of the preceding claims, wherein,
each first step portion (STP1) of the plurality of first step portions is a fence-type step portion, and
the dividing includes positioning the stage (STG) in relation to the slimmed mother substrate (MSUBs) such that, in a plan view, the plurality of first step portions surround separate, respective display cells (DPC) of the plurality of display cells.

8. The method of any one of the preceding claims, wherein each first step portion (STP1) of the plurality of first step portions includes a plurality of island-type step portions spaced apart from each other.

9. The method of any one of the preceding claims, wherein the stage (STG) comprises a plurality of suction holes (VCH), the plurality of suction holes including at least one of
one or more first suction holes (VCH1) surrounded by one first step portion (STP1) of the plurality of first step portions in a plan view, or
one or more second suction holes (VCH2) between at least two separate first step portions (STP1) of the plurality of first step portions in the plan view.

10. A display device (10) manufactured according to the method of claim 1, the display device comprising:
a substrate (SUB), the substrate including a display area (DA) and a non-display area (NDA) at least partially surrounding the display area;
a light emitting element layer (EML) on the substrate, the light emitting element layer including a plurality of light emitting elements (LEL) on the display area; and
a thin-film transistor layer (TFTL) between the substrate and the light emitting element layer.

11. An electronic device (1), comprising:
the display device (10) of claim 10;
a processor (12) configured to provide an operation signal to the display device; and
a power module (14) configured to supply a voltage to the display device and the processor.
